(19) Europäisches Patentamt / European Patent Office / Office européen des brevets

(11) **EP 4 557 915 A1**

(12) **EUROPEAN PATENT APPLICATION**

(43) Date of publication:
   **21.05.2025 Bulletin 2025/21**

(21) Application number: **24205304.9**

(22) Date of filing: **08.10.2024**

(51) International Patent Classification (IPC):
   **H10F 39/00** (2025.01)

(52) Cooperative Patent Classification (CPC):
   **H10F 39/8053; H10F 39/8063**

(84) Designated Contracting States:
   **AL AT BE BG CH CY CZ DE DK EE ES FI FR GB GR HR HU IE IS IT LI LT LU LV MC ME MK MT NL NO PL PT RO RS SE SI SK SM TR**
   Designated Extension States:
   **BA**
   Designated Validation States:
   **GE KH MA MD TN**

(30) Priority: **14.11.2023 KR 20230157693**

(71) Applicant: **Samsung Electronics Co., Ltd Suwon-si, Gyeonggi-do 16677 (KR)**

(72) Inventors:
   • **Roh, Younggeun**
     **16678 Suwon-si, Gyeonggi-do (KR)**
   • **Roh, Sookyoung**
     **16678 Suwon-si, Gyeonggi-do (KR)**
   • **Kim, Hyochul**
     **16678 Suwon-si, Gyeonggi-do (KR)**

(74) Representative: **Grünecker Patent- und Rechtsanwälte PartG mbB Leopoldstraße 4 80802 München (DE)**

(54) **IMAGE SENSOR INCLUDING SPECTRAL FILTER AND ELECTRONIC APPARATUS INCLUDING THE IMAGE SENSOR**

(57)   Provided are an image sensor including a spectral filter and an electronic apparatus. An image sensor includes a sensor substrate including a plurality of pixels configured to sense light, and a spectral filter configured to separate incident light into at least four different wavelength bands and to provide the separated incident light to the plurality of pixels. The spectral filter includes a routing filter array including a plurality of nano-structures configured to color-separate the incident light into at least three different wavelength bands and to condense the light onto the plurality of pixels, and a spectral filter array between the sensor substrate and the routing filter array, and including a plurality of unit filters having different transmission spectrums, the plurality of unit filters respectively corresponding to the plurality of pixels.

FIG. 1

# Description

BACKGROUND

1. Field

The present disclosure relates generally to image sensors, and more particularly, to an image sensor including a spectral filter and an electronic apparatus.

2. Description of the Related Art

Related image sensors may classify incident light into one of three wavelength bands (e.g., red (R), green (G), and blue (G) wavelength bands). However, improvements in color reproduction accuracy and/or object recognition performance may be potentially achieved with an image sensor provided with a spectral filter that may divide wavelength bands into more sections. For example, a spectral filter may be used for a dedicated camera including, but not being limited to, optical device components that may have relatively large volumes and/or relatively high complexity levels. Alternatively or additionally, a module technique for an image sensor including a spectral filter integrated on a semiconductor chip may be desirable.

Thus, there exists a need for further improvements in image sensor technology, as the need for improved color reproduction accuracy and object recognition may be constrained by relatively large volumes and/or relatively high complexity levels. Improvements are presented herein. These improvements may also be applicable to other imaging technologies.

SUMMARY

The invention is what is claimed in the independent claims. Preferred embodiments are specified in the dependent claims.

One or more example embodiments of the present disclosure provide for image sensors including spectral filters.

Further, one or more example embodiments of the present disclosure provide for electronic devices including the image sensors.

According to an aspect of the present disclosure, an image sensor includes a sensor substrate including a plurality of pixels configured to sense light, and a spectral filter configured to separate incident light into at least four different wavelength bands and to provide the separated incident light to the plurality of pixels. The spectral filter includes a routing filter array including a plurality of nano-structures configured to color-separate the incident light into at least three different wavelength bands and to condense the separated incident light onto the plurality of pixels, and a spectral filter array between the sensor substrate and the routing filter array, and including a plurality of unit filters having different transmission spectrums, the plurality of unit filters respectively corresponding to the plurality of pixels.

In some embodiments, the routing filter array may include a first meta-region, a second meta-region, a third meta-region, and a fourth meta-region. Each of the first meta-region, the second meta-region, the third meta-region, and the fourth meta-region may correspond to one of the plurality of pixels and to one of the plurality of unit filters. The plurality of nano-structures may be disposed in each of the first meta-region, the second meta-region, the third meta-region, and the fourth meta-region. The plurality of nano-structures may be further configured to change a phase of the incident light.

In some embodiments, the plurality of nano-structures may be further configured to condense a first light of incident light onto first pixels corresponding to the first meta-region and the fourth meta-region, the first light having a first wavelength band, the incident light being incident on the first meta-region, the second meta-region, the third meta-region, and the fourth meta-region, condense a second light of the incident light onto a second pixel corresponding to the second meta-region, the second light having a second wavelength band, and condense a third light of the incident light onto a third pixel corresponding to the third meta-region, the third light having a third wavelength band.

In some embodiments, the plurality of nano-structures may be further configured to condense a first light of incident light onto a first pixel corresponding to the first meta-region, the first light having a first wavelength band, the incident light being incident on the first meta-region, the second meta-region, the third meta-region, and the fourth meta-region, condense a second light of the incident light onto a second pixel corresponding to the second meta-region, the second light having a second wavelength band, condense a third light of the incident light onto a third pixel corresponding to the third meta-region, the third light having a third wavelength band, and condense a fourth light of the incident light onto a fourth pixel corresponding to the fourth meta-region, the fourth light having a fourth wavelength band.

In some embodiments, the routing filter array may further include a first meta-region, a second meta-region, a third meta-region, and a fourth meta-region. Each of the first meta-region, the second meta-region, the third meta-region, and the fourth meta-region correspond to four pixels arranged in a 2×2 array from among the plurality of pixels and correspond to four unit filters arranged in the 2×2 array from among the plurality of unit filters. The plurality of nano-structures may be disposed in each of the first meta-region, the second meta-region, the third meta-region, and the fourth meta-region. The plurality of nano-structures may be further configured to change a phase of the incident light.

In some embodiments, the plurality of nano-structures may be further configured to condense a first light of incident light onto four first pixels respectively corresponding to the first meta-region and the fourth meta-region, the first light having a first wavelength band, the incident light being incident on the first meta-region, the second meta-region, the third meta-region, and the fourth meta-region, condense a second light of the incident light onto four second pixels corresponding to the second meta-region, the second light having a second wavelength band, and condense a third light of the incident light onto four third pixels corresponding to the third meta-region, the third light having a third wavelength band.

In some embodiments, the plurality of nano-structures may be further configured to condense a first light of incident light onto four first pixels corresponding to the first meta-region, the first light having a first wavelength band, the incident light being incident on the first meta-region, the second meta-region, the third meta-region, and the fourth meta-region, condense a second light of the incident light onto four second pixels corresponding to the second meta-region, the second light having a second wavelength band, condense a third light of the incident light onto four third pixels corresponding to the third meta-region, the third light having a third wavelength band, and condense a fourth light of the incident light onto four fourth pixels corresponding to the fourth meta-region, the fourth light having a fourth wavelength band.

In some embodiments, each of the plurality of unit filters may include a first reflector, a second reflector above the first reflector, and a cavity between the first reflector and the second reflector. Each each of the plurality of unit filters may have a transmission spectrum with at least two different transmission peak wavelengths.

In some embodiments, a plurality of cavities of the plurality of unit filters may have a same thickness.

In some embodiments, the cavity may include a cavity lower layer having a lower dielectric pattern formed by a first dielectric material having a first refractive index and a second dielectric material having a second refractive index that is greater than the first refractive index, and a cavity upper layer having an upper dielectric pattern formed by a third dielectric material having a third refractive index and a fourth dielectric material having a fourth refractive index that is greater than the third refractive index.

In some embodiments, a first effective refractive index of the cavity lower layer may be determined according to a first volume ratio of a first volume occupied by the first dielectric material to a second volume occupied by the second dielectric material in the cavity lower layer. A second effective refractive index of the cavity upper layer may be determined according to a second volume ratio of a third volume occupied by the third dielectric material to a fourth volume occupied by the fourth dielectric material in the cavity upper layer. The effective refractive indexes and thicknesses of the cavity lower layer and the cavity upper layer are determined in each of the plurality of unit filters, such that each of the plurality of unit filters has a transmission spectrum having at least two different peak wavelengths.

In some embodiments, two or more of a plurality of cavities in the plurality of unit filters may have same lower dielectric patterns and same upper dielectric patterns.

In some embodiments, a plurality of spectral channels may be formed by combinations of the routing filter array and the plurality of unit filters of the spectral filter array. A number of cavities of a plurality of cavities having different lower dielectric patterns or different upper dielectric patterns in the spectral filter array is less than a number of spectral channels.

In some embodiments, based on the image sensor having N spectral channels and the routing filter array separating and condensing the incident light of A wavelength bands, a number N' of cavities having different lower dielectric patterns or different upper dielectric patterns satisfies a condition

$$\frac{N}{A} \leq N' < N$$

, wherein N and A are positive integers greater than or equal to four.

In some embodiments, the cavity may further include a dielectric separation layer between the cavity lower layer and the cavity upper layer. The dielectric separation layer may have a refractive index less than or equal to the second refractive index or the fourth refractive index.

In some embodiments, the dielectric separation layer includes at least one of hafnium oxide ($HfO_2$) or titanium oxide ($TiO_2$).

In some embodiments, the dielectric separation layer may have a thickness of about 10 nm to about 100 nm.

In some embodiments, a bandwidth of the transmission spectrum of the routing filter array may be greater than a bandwidth of the transmission spectrum of each of the plurality of unit filters in the spectral filter array.

In some embodiments, the spectral filter may further include a spacer layer between the spectral filter array and the routing filter array. The spacer layer may have a refractive index that is less than refractive indexes of the plurality of nano-structures.

According to an aspect of the present disclosure, an electronic apparatus includes a lens assembly configured to form an optical image of a subject, an image sensor configured to convert the optical image formed by the lens assembly into an electrical signal, and a processor configured to process a signal generated by the image sensor. The image sensor includes a sensor substrate including a plurality of pixels configured to sense light, and a spectral filter configured to separate incident light into at least four different wavelength bands and to provide the separated incident light to the plurality of pixels. The spectral filter includes a routing filter array including a plurality of nano-structures configured to color-separate the incident light into at least three different wavelength bands and to condense the separated incident light onto the plurality of pixels, and a spectral filter array between the sensor substrate and the routing filter array, and including a plurality of unit filters having different transmission spectrums, the plurality of unit filters respectively corresponding to the plurality of pixels.

Additional aspects may be set forth in part in the description which follows and, in part, may be apparent from the description, and/or may be learned by practice of the presented embodiments.

BRIEF DESCRIPTION OF THE DRAWINGS

The above and other aspects, features, and advantages of certain embodiments of the present disclosure may be more apparent from the following description taken in conjunction with the accompanying drawings, in which:

FIG. 1 is a schematic block diagram of an image sensor, according to an embodiment;

FIG. 2 is a cross-sectional view schematically showing a structure of a pixel array in an image sensor, according to an embodiment;

FIG. 3 is a plan view showing an arrangement of a plurality of regions in a routing filter array shown in FIG. 2, according to an embodiment;

FIG. 4 is a diagram showing an example of a plurality of nano-structures arranged in a plurality of meta-regions of a routing filter array, according to an embodiment;

FIG. 5 is a diagram showing an example of a phase profile of green light and blue light passing through the routing filter array including a plurality of nano-structures shown in FIG. 4, according to an embodiment;

FIG. 6 is a diagram showing an example of a phase profile of red light and green light passing through the routing filter array including a plurality of nano-structures shown in FIG. 4, according to an embodiment;

FIG. 7 is a diagram showing an example of an array of a green light condensing region formed by a routing filter array, according to an embodiment;

FIG. 8 is a diagram showing an example of an array of a blue light condensing region formed by a routing filter array, according to an embodiment;

FIG. 9 is a diagram showing an example of an array of a red light condensing region formed by a routing filter array, according to an embodiment;

FIG. 10 is a plan view showing an example of an arrangement of a plurality of unit filters in the spectral filter array shown in FIG. 2, according to an embodiment;

FIG. 11 is a cross-sectional view showing an example of a cross-sectional structure of spectral filters in a spectral filter array, according to an embodiment;

FIGS. 12A to 12D are plan views showing examples of lower dielectric patterns that may be applied to a cavity lower layer shown in FIG. 11, according to an embodiment;

FIGS. 13A and 13B are plan views showing examples of lower dielectric patterns that may be applied to a cavity lower layer shown in FIG. 11, according to an embodiment;

FIG. 14 is a diagram of simulation results showing example transmission spectrums of unit filters shown in FIG. 11, according to an embodiment;

FIG. 15 is a cross-sectional view schematically showing a structure of a pixel array in an image sensor, according to an embodiment;

FIGS. 16A and 16B are diagrams of simulation results showing example transmission spectrums of unit filters shown in FIG. 15, according to an embodiment;

FIGS. 17A and 17B are diagrams of simulation results showing example transmission spectrums of unit filters shown in FIG. 15, according to an embodiment;

FIG. 18 is a cross-sectional view schematically showing a structure of a pixel array in an image sensor, according to an embodiment;

FIG. 19 is a plan view showing an example of a configuration in a routing filter array shown in FIG. 18, according to an embodiment;

FIG. 20 is a plan view showing examples of different dielectric patterns respectively arranged in a plurality of unit filters of a spectral filter array, according to an embodiment;

FIG. 21 is a cross-sectional view schematically showing a structure of a pixel array in an image sensor, according to an embodiment;

FIG. 22 is a graph showing a difference in light utilization efficiency between an image sensor using a routing filter array and an image sensor using a general red-green-blue (RGB) filter array, according to an embodiment;

FIG. 23 is a block diagram of an electronic device including an image sensor, according to an embodiment;

FIG. 24 is a block diagram schematically showing a camera module of FIG. 23, according to an embodiment;

FIG. 25 is a block diagram of an electronic device including a multi-camera module, according to an embodiment; and

FIG. 26 is a detailed block diagram of the multi-camera module in the electronic device of FIG. 25, according to an embodiment.

DETAILED DESCRIPTION

Reference is made to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. That is, as used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases.

Hereinafter, an image sensor including a spectral filter and an electronic apparatus including the image sensor is described with reference to accompanying drawings. The embodiments of the disclosure are capable of various modifications and may be embodied in many different forms. In the drawings, sizes of components in the drawings may be exaggerated for convenience of explanation.

When a layer, a film, a region, or a panel is referred to as being "on" another element, it may be directly on/under/at left/right sides of the other layer or substrate, or intervening layers may also be present. In addition, when an element or layer is referred to as "covering" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

It is to be understood that although the terms "first," "second," and the like may be used to describe various components, these components should not be limited by these terms. These terms are only used to distinguish one component from another. These terms do not limit that materials or structures of components may be different from one another.

An expression used in the singular encompasses the expression of the plural, unless it has a clearly different meaning in the context. It is to be further understood that when a portion is referred to as "comprising" another component, the portion may not exclude another component but may further comprise another component unless the context states otherwise.

In addition, the terms such as "... unit", "module", and the like provided herein may indicate a unit performing a function or operation, and may be realized by hardware, software, or a combination of hardware and software.

The use of the terms of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc., and the like) is only to describe the scope in detail, but the scope is not limited by these terms unless the context is limited by the claims.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

The embodiments herein may be described and illustrated in terms of blocks, as shown in the drawings, which carry out a described function or functions. These blocks, which may be referred to herein as units or modules or the like, or by names such as device, logic, circuit, controller, counter, comparator, generator, converter, or the like, may be physically implemented by analog and/or digital circuits including one or more of a logic gate, an integrated circuit, a microprocessor, a microcontroller, a memory circuit, a passive electronic component, an active electronic component, an optical component, and the like.

In the present disclosure, the articles "a" and "an" are intended to include one or more items, and may be used interchangeably with "one or more." Where only one item is intended, the term "one" or similar language is used. For example, the term "a processor" may refer to either a single processor or multiple processors. When a processor is described as carrying out an operation and the processor is referred to perform an additional operation, the multiple operations may be executed by either a single processor or any one or a combination of multiple processors.

As used herein, each of the terms "$Al_2O_3$", "GaAs", "GaN", "GaP", "$Si_3N_4$", "SiC", "$SiO_2$", "TiN", "$TiO_2$", "ZnS", "ZnSe", and the like may refer to a material made of elements included in each of the terms and is not a chemical formula representing a stoichiometric relationship.

Hereinafter, various embodiments of the present disclosure are described with reference to the accompanying drawings.

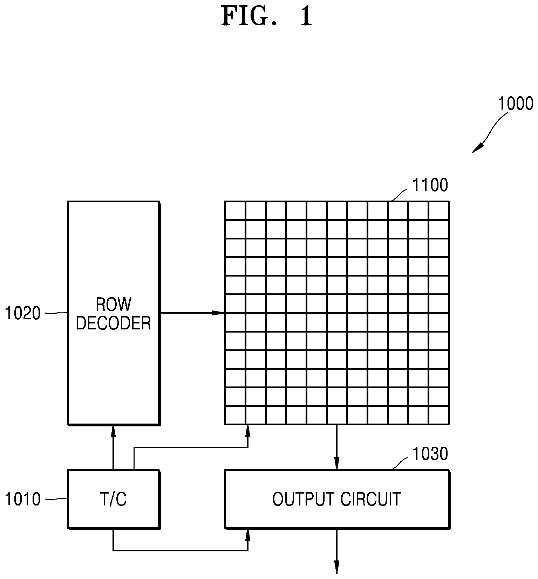

FIG. 1 is a schematic block diagram of an image sensor 1000, according to an embodiment. Referring to FIG. 1, the image sensor 1000 may include a pixel array 1100, a timing controller (T/C) 1010, a row decoder 1020, and an output circuit 1030. The image sensor 1000 may be and/or may include a charge-coupled device (CCD) image sensor or a complementary metal oxide semiconductor (CMOS) image sensor.

The pixel array 1100 may include pixels that may be two-dimensionally (2D) disposed in a plurality of rows and columns. The row decoder 1020 may select one of the rows in the pixel array 1100 in response to a row address signal output from the timing controller 1010. The output circuit 1030 may output a photosensitive signal from a plurality of pixels disposed in the selected row in a column unit. To this end, the output circuit 1030 may include a column decoder and an analog-to-digital converter (ADC). For example, the output circuit 1030 may include a plurality of ADCs that may be respectively disposed in columns between the column decoder and the pixel array 1100, or one ADC disposed at an output end of the column decoder. The timing controller 1010, the row decoder 1020, and the output circuit 1030 may be implemented as one chip or in separate chips. At least one processor for processing an image signal output from the output circuit 1030 may be implemented as one chip with the timing controller 1010, the row decoder 1020, and the output circuit 1030.

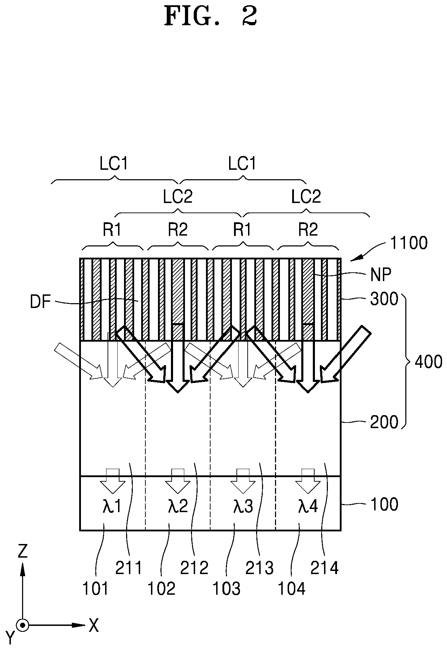

FIG. 2 is a cross-sectional view schematically showing the pixel array 1100 of the image sensor 1000, according to an embodiment. Referring to FIG. 2, the pixel array 1100 may include a sensor substrate 100 and a spectral filter 400 arranged to face an upper surface (or a light incident surface) of the sensor substrate 110.

The sensor substrate 100 may include a plurality of pixels for sensing incident light. For example, the sensor substrate 100 may include a first pixel 101, a second pixel 102, a third pixel 103, and a fourth pixel 104 that may convert incident light into electrical signals and may generate an image signal. In the cross-sectional view of FIG. 2, the first pixel 101, the second pixel 102, the third pixel 103, and the fourth pixel 104 are only shown, however, the sensor substrate 100 may include a plurality of pixels arranged in a two-dimensional array in a first direction (X-direction) and a second direction (Y-direction). That is, the present disclosure is not limited in this regard, and the sensor substrate 100 may include more than four (4) pixels (e.g., > 4) or less than four (4) pixels (e.g., < 4).

The spectral filter 400 may be configured to separate incident light into at least four (4) different wavelength bands and provide the light of four (4) different wavelength bands respectively to the plurality of pixels of the sensor substrate 110. As a result, the image sensor 1000 may include at least four (4) different spectral channels. For example, the spectral filter 400 may be configured to provide, in the incident light, light of a first spectral channel $\lambda 1$ to the first pixel 101, light of a second spectral channel $\lambda 2$ that is different from the first spectral channel $\lambda 1$ to the second pixel 102, light of a third spectral channel $\lambda 3$ that is different from the first spectral channel $\lambda 1$ and the second spectral channel $\lambda 2$ to the third pixel 103, and light of a fourth spectral channel $\lambda 4$ that is different from the first to third spectral channels $\lambda 1$ to $\lambda 3$ to the fourth pixel 104.

The spectral filter 400 may include a spectral filter array 200 and a routing filter array 300. The spectral filter array 200 may be arranged to face an upper surface (or a light incident surface) of the sensor substrate 100 in a third direction (Z-direction). The routing filter array 300 may be arranged to face an upper surface of the spectral filter array 200 in the third direction. The spectral filter array 200 may be arranged between the sensor substrate 100 and the routing filter array 300. Consequently, the incident light incident on the pixel array 1100 of the image sensor 1000 may pass through the routing filter array 300, and may subsequently reach the sensor substrate 100 via the spectral filter array 200.

The spectral filter array 200 may include a plurality of unit filters (e.g., first unit filter 211, second unit filter 212, third unit filter 213, and fourth unit filter 214) that may have different transmission spectrums and may correspond to the plurality of pixels in a one-to-one correspondence. For example, the first unit filter 211 may correspond to the first pixel 101 and may face the first pixel 101 in the third direction, the second unit filter 212 may correspond to the second pixel 102 and may face the second pixel 102 in the third direction, the third unit filter 213 may correspond to the third pixel 103 and may face the third pixel 103 in the third direction, and the fourth unit filter 214 may correspond to the fourth pixel 104 and may face the fourth pixel 104 in the third direction. In the cross-sectional view of FIG. 2, the first unit filter 211, the second unit filter 212, the third unit filter 213, and the fourth unit filter 214 are only shown, however, the present disclosure is not limited in this regard. That is, the spectral filter array 200 may include a plurality of unit filters that may be arranged in a 2D array in the first and second directions.

The routing filter array 300 may color-separate the incident light into at least three (3) different wavelength bands, each of which may be relatively wider when compared with the first to fourth unit filters 211 to 214 of the spectral filter array 200. For example, the routing filter array 300 may separate light of a first wavelength band (e.g., green light), light of a second wavelength band (e.g., blue light), and light of a third wavelength band (e.g., red light) from the incident light and make the light of different wavelength bands progress in different paths. Alternatively or additionally, the routing filter array 300 may separate light of a first wavelength band (e.g., green light), light of a second wavelength band (e.g., blue light), light of a third wavelength band (e.g., red light), and light of a fourth wavelength band (e.g., infrared ray) from the incident light and make the light of different wavelength bands progress in different paths. Various spectral channels may be formed through combinations of the routing filter array 300 and the spectral filter array 200. For example, sixteen (16) or more spectral channels may be formed through the combinations of the routing filter array 300 and the spectral filter array 200. However, the present disclosure is not limited in this regard, and other numbers of spectral channels may be formed through the combinations of the routing filter array 300 and the spectral filter array 200

The routing filter array 300 may be configured to act as a lens condensing color-separated light. In an embodiment, the routing filter array 300 may include a plurality of nano-structures NP that may be regularly arranged according to a certain rule. Alternatively or additionally, the routing filter array 300 may further include a dielectric filler DF filled among the plurality of nano-structures NP. In the routing filter array 300, the number, cross-sectional sizes, and/or arrangement type of the plurality of nano-structures NP may vary depending on a plurality of regions that may be regularly arranged. That is, the routing filter array 300 may include a plurality of meta-regions (e.g., first meta-region R1 and second meta-region R2), in which the number, the cross-sectional sizes, or the arrangement type of the plurality of nano-structures NP may be different. For example, the light of a first wavelength incident on a first light condensing region LC1 and light of a second wavelength incident on a second light condensing region LC2 of the light incident on the routing filter array 300 may be separated and/or condensed onto different pixels. The plurality of nano-structures NP in the routing filter array 300 may be variously formed so that the routing filter array 300 may perform the above functions.

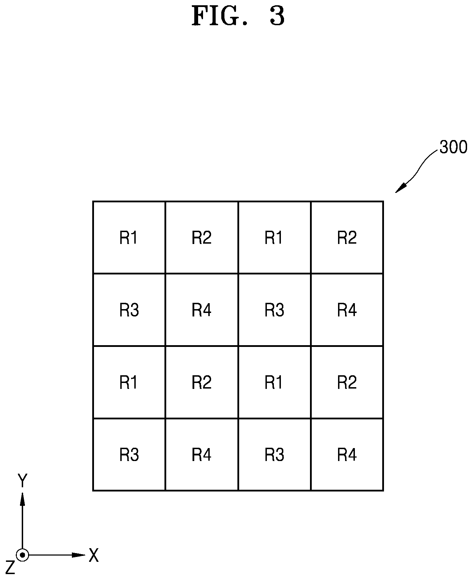

FIG. 3 is a plan view showing an arrangement of a plurality of regions in the routing filter array 300 shown in FIG. 2. Referring to FIG. 3, the routing filter array 300 may include a first meta-region R1, a second meta-region R2, a third meta-region R3, and a fourth meta-region R4 that may be two-dimensionally (2D) arranged. Each of the first meta-region R1, the second meta-region R2, the third meta-region R3, and the fourth meta-region R4 may correspond to one of the plurality of pixels in the sensor substrate 100 and one of the plurality of unit filters in the spectral filter array 200. Alternatively or additionally, each of the first meta-region R1, the second meta-region R2, the third meta-region R3, and the fourth meta-region R4 may be arranged to face the corresponding pixel and the corresponding unit filter in the third direction.

The first meta-region R1, the second meta-region R2, the third meta-region R3, and the fourth meta-region R4 arranged in a 2×2 array may form one unit pattern. The first meta-region R1, the second meta-region R2, the third meta-region R3, and the fourth meta-region R4 may be arranged respectively on quadrant regions of one unit pattern. For example, the first meta-region R1 and the second meta-region R2 may be arranged adjacent to each other in the first direction, the third meta-region R3 and the fourth meta-region R4 may be arranged adjacent to each other in the first direction, the first meta-region R1 and the third meta-region R3 may be arranged adjacent to each other in the second direction, and the second meta-region R2 and the fourth meta-region R4 may be arranged adjacent to each other in the second direction. Alternatively or additionally, the first meta-region R1 and the fourth meta-region R4 may be arranged in a diagonal direction of the unit pattern, and the second meta-region R2 and the third meta-region R3 may be arranged in another diagonal direction of the unit pattern.

The routing filter array 300 may include a plurality of unit patterns. Each of the plurality of unit patterns may include the first meta-region R1, the second meta-region R2, the third meta-region R3, and the fourth meta-region R4. For example, a plurality of first meta-regions R1 and a plurality of second meta-regions R2 may be alternately arranged in the first direction, and a plurality of third meta-regions R3 and a plurality of fourth meta-regions R4 may be alternately arranged in the first direction in another cross-section at different position in the second direction that may be perpendicular to the first direction. That is, the routing filter array 300 may include the plurality of unit patterns that may be two-dimensionally and regularly arranged in the first direction and the second direction.

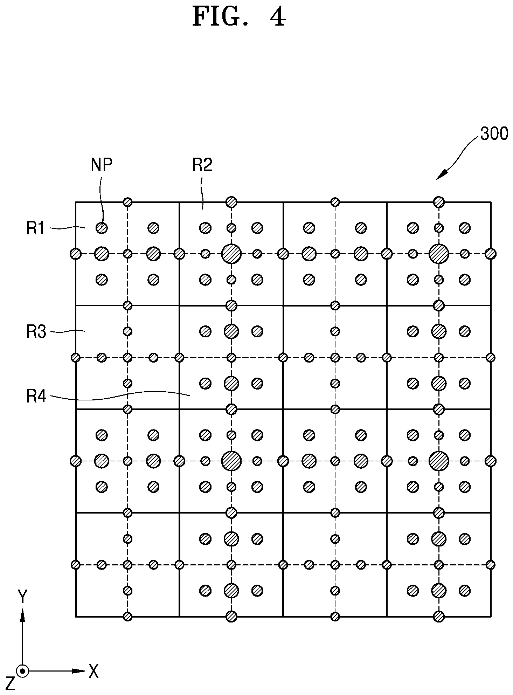

The routing filter array 300 may include the plurality of nano-structures NP that may be two-dimensionally arranged in each of the first to fourth meta regions R1 to R4 so as to color-separate and condense the incident light. FIG. 4 shows an example of the plurality of nano-structures NP arranged in the plurality of first to fourth meta-regions R1 to R4 of the routing filter array 300. The plurality of nano-structures NP may be arranged such that a phase of light transmitting through the routing filter array 300 may be changed according to a position on the routing filter array 300. A phase profile of the transmitted light, which may be implemented by the routing filter array 300, may be determined according to the number, the cross-sectional size (e.g., width and/or diameter), cross-sectional shape, a height of each nano-structure NP, an arrangement period (or pitch) and arrangement type of the plurality of nano-structures NP. Alternatively or additionally, the behavior of the light passing through the routing filter array 300 may be determined according to the phase profile of the transmitted light. For example, the plurality of nano-structures NP may be disposed to form a phase profile that may allow the light that has been transmitted through the routing filter array 300 to be separated according to wavelengths and condensed.

The nano-structures NP may each have a size that may be less than a wavelength of visible light. The nano-structures NP may have a size that may be less than, for example, a blue wavelength. For example, the cross-sectional width (and/or diameter) of the nano-structures NP may be less than 400 nanometers (nm), 300 nm, and/or 200 nm. A height of the nano-structures NP may be about 500 nm to about 1500 nm, and/or may be greater than the cross-sectional width of the nano-structures NP.

The nano-structures NP may include a material having a relatively higher refractive index as compared with a peripheral material and having a relatively lower absorption ratio in the visible ray band. For example, the nano-structures NP may include c-Si, p-Si, a-Si and a Group III-V compound semiconductor (e.g.. GaP, GaN, GaAs, and the like), SiC, $TiO_2$, $Si_3N_4$, ZnS, ZnSe, and/or a combination thereof. Periphery of the nano-structures NP may be filled with a dielectric filler DF having a relatively lower refractive index when compared with the nano-structures NP and may have a relatively low absorbent ratio in the visible ray band. For example, the dielectric filler DF may include siloxane-based spin on glass (SOG), $SiO_2$, $Si_3N_4$, $Al_2O_3$, air, and the like.

The refractive index of the nano-structures NP may be greater than or equal to about 2.0 with respect to light of about 630 nm wavelength, and the refractive index of the dielectric filler DF may be about 1.0 to about 2.0 or less with respect to light of about 630 nm wavelength. In an embodiment, a difference between the refractive indexes of the nano-structures NP and the refractive index of the dielectric filler DF may be greater than or equal to about 0.5. The nano-structures NP having a difference in a refractive index between the refractive index of the peripheral material may change the phase of light that passes through the nano-structures NP. The phase change may be caused by phase delay that may occur due to the shape dimension of the sub-wavelength of the nanostructures NP, and a degree at which the phase is delayed may be determined by a detailed shape dimension and arrangement shape of the nanostructures NP.

In the example of FIG. 4, each of the first meta-region R1, the second meta-region R2, the third meta-region R3, and the fourth meta-region R4 may include the plurality of nano-structures NP. In the first meta-region R1, the second meta-region R2, the third meta-region R3, and the fourth meta-region R4, the cross-sectional sizes and arrangement type of the plurality of nano-structures NP may be different. Alternatively or additionally, the number of the plurality of nano-structures NP in each of the first meta-region R1, the second meta-region R2, the third meta-region R3, and the fourth meta-region R4 may be different from those of the others. The number, the cross-sectional size, the cross-sectional shape, and the arrangement type of the plurality of nano-structures NP shown in FIG. 4 are examples, and the first meta-region R1, the second meta-region R2, the third meta-region R3, and the fourth meta-region R4 may each include the plurality of nano-structures NP having various number, cross-sectional sizes, cross-sectional shapes, and arrangement types.

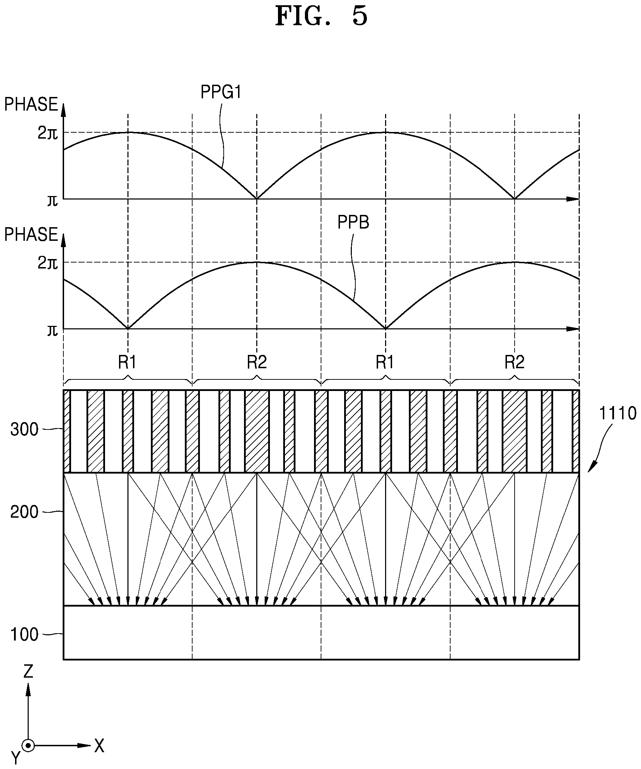

FIG. 5 is a diagram showing an example of phase profiles of green light and blue light passing through the routing filter array 300 including the plurality of nano-structures NP, shown in FIG. 4. Referring to FIG. 5, the green light that has passed through the routing filter array 300 may have a first green light phase profile PPG1 that may be the largest at the center of the first meta-region R1 and may reduce away from the center of the first meta-region R1. For example, at a position immediately after passing through the routing filter array 300, that is, on the lower surface of the routing filter array 300, the phase of the green light may be largest at the center of the first meta-region R1 and may reduce into a concentric circle away from the center of the first meta-region R1.

As another example, the blue light that has passed through the routing filter array 300 may have a blue light phase profile PPB that may be largest at the center of the second meta-region R2 and may reduce away from the center of the second meta-region R2. For example, at a position immediately after passing through the routing filter array 300, that is, on the lower surface of the routing filter array 300, the phase of the blue light may be largest at the center of the second meta-region R2 and may reduce into a concentric circle away from the center of the second meta-region R2.

In an embodiment, in the incident light that is incident on the first meta-region R1 and the incident light that is incident on a portion of the second meta-region R2 and a portion of the third meta-region R3 around the first meta-region R1, the green light may be condensed onto a pixel corresponding to the first meta-region R1 by the routing filter array 300. Alternatively or additionally, in the incident light that is incident on the second meta-region R2 and the incident light that is incident on a portion of the first meta-region R1, a portion of the third meta-region R3, and a portion of the fourth meta-region R4 around the second meta-region R2, the blue light may be condensed onto a pixel corresponding to the second meta-region R2 by the routing filter array 300.

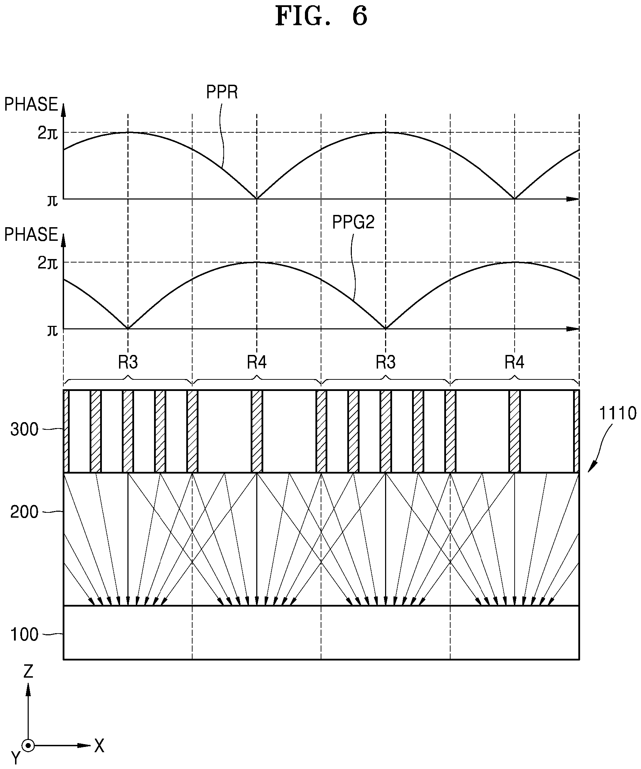

FIG. 6 is a diagram showing an example of phase profiles of red light and green light passing through the routing filter array 300 including the plurality of nano-structures NP, shown in FIG. 4. Referring to FIG. 6, the red light that has passed through the routing filter array 300 may have a red light phase profile PPR that may be the largest at the center of the third meta-region R3 and may reduce away from the center of the third meta-region R3. For example, at a position immediately after passing through the routing filter array 300, that is, on the lower surface of the routing filter array 300, the phase of the red light may be largest at the center of the third meta-region R3 and may reduce into a concentric circle away from the center of the third meta-region R3.

In an embodiment, the green light that has passed through the routing filter array 300 may have a second green light phase profile PPG2 that may be largest at the center of the fourth meta-region R4 and may reduce away from the center of the fourth meta-region R4. Except that the second green light phase profile PPG2 may have the largest phase at the center of the fourth meta-region R4, the descriptions with reference to the first green light phase profile PPG1 may be also applied to the second green light phase profile PPG2.

In an embodiment, in the incident light that is incident on the third meta-region R3 and the incident light that is incident on a portion of the first meta-region R1, a portion of the second meta-region R2, and a portion of the fourth meta-region R4 around the third meta-region R3, the red light may be condensed onto a pixel corresponding to the third meta-region R3 by the routing filter array 300. Alternatively or additionally, in the incident light that is incident on the fourth meta-region R4 and the incident light that is incident on a portion of the second meta-region R2 and a portion of the third meta-region R3 around the fourth meta-region R4, the green light may be condensed onto a pixel corresponding to the fourth meta-region R4 by the routing filter array 300.

Therefore, the routing filter array 300 may condense, in the incident light, green light onto the pixels corresponding to the first meta-region R1 and the fourth meta-region R4, blue light onto the pixel corresponding to the second meta-region R2, and red light onto the pixel corresponding to the third meta-region R3. That is, the incident light may be separated by the routing filter array 300, according to wavelengths, with substantially no loss and/or may be condensed onto the pixels.

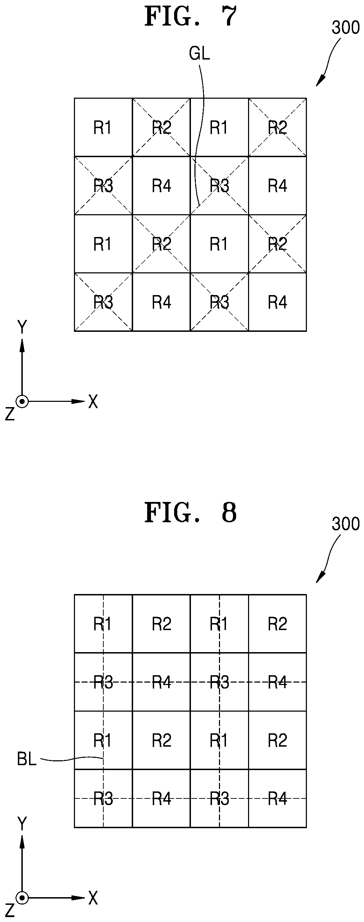

FIG. 7 is a diagram showing an example of an array in a green light condensing region formed by the routing filter array 300. Referring to FIG. 7, the phase profile of the green light described above with reference to FIGS. 5 and 6 may condense the green light onto the pixels corresponding to the first meta-region R1 and the fourth meta-region R4, wherein the green light has passed through a green light condensing region GL obtained by connecting centers of two second meta-regions R2 to centers of two third meta-regions R3, which may be adjacent to the first meta-region R1 and the fourth meta-region R4 while contacting one sides thereof. Therefore, as shown in FIG. 7, the routing filter array 300 may operate as an array of the green light condensing region GL condensing the green light onto the pixels corresponding to the first meta-region R1 and the fourth meta-region R4. The green light condensing region GL may have an area that may be, for example, 1.2 to 2 times greater than that of the corresponding pixel. However, the present disclosure is not limited in this regard.

FIG. 8 is a diagram showing an example of an array of a blue light condensing region formed by the routing filter array 300. Referring to FIG. 8, according to the phase profile of the blue light described with reference to FIG. 5, the blue light that has passed through a blue light condensing region BL obtained by connecting the centers of four third meta-regions R3 that may be adjacent to the second meta-region R2 at apexes thereof may be condensed onto the pixel corresponding to the second meta-region R2. Therefore, as shown in FIG. 8, the routing filter array 300 may operate as an array of the blue light condensing region BL condensing the blue light onto the pixel corresponding to the second meta-region R2. The blue light condensing region BL may have an area that is, for example, 1.5 to 4 times greater than that of the corresponding pixel. However, the present disclosure is not limited in this regard. The blue light condensing region BL may partially overlap a portion of the green light condensing region GL and a portion of a red light condensing region RL that will be described later.

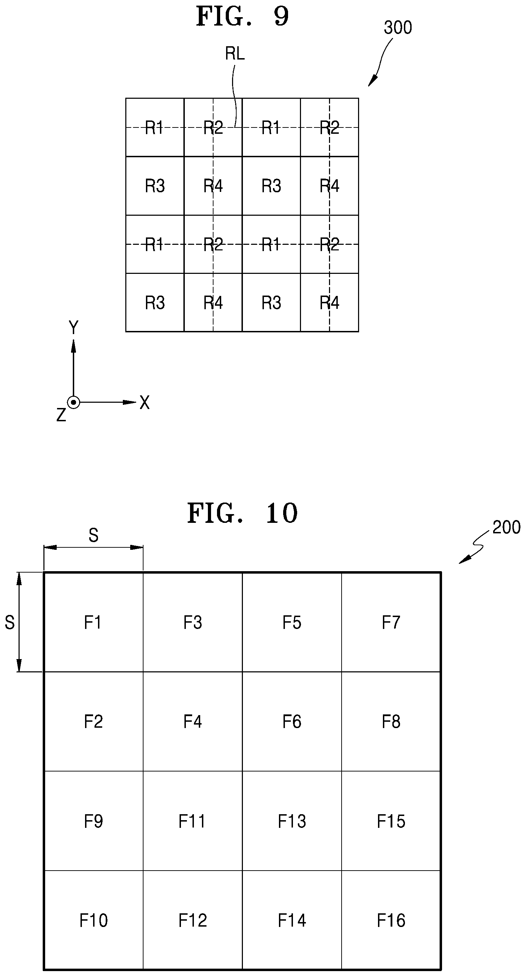

FIG. 9 is a diagram showing an example of an array in a red light condensing region RL formed by the routing filter array 300. Referring to FIG. 9, according to the phase profile of the red light described with reference to FIG. 6, the red light that has passed through the red light condensing region RL obtained by connecting the centers of four second meta-regions R2 that may be adjacent to the third meta-region R3 at apexes thereof may be condensed onto the pixel corresponding to the third meta-region R3. Therefore, as shown in FIG. 9, the routing filter array 300 may operate as an array of the red light condensing region RL condensing the red light onto the pixel corresponding to the third meta-region R3. The red light condensing region RL may have an area that is, for example, 1.5 to 4 times greater than that of the corresponding pixel. However, the present disclosure is not limited in this regard. The red light condensing region RL may partially overlap a portion of the green light condensing region GL and a portion of the blue light condensing region BL.

As described with reference to FIGS. 5 to 9, the routing filter array 300 may separate and condense the green light, the blue light, and the red light from the incident light. However, the present disclosure is not limited thereto. For example, according to the number, the cross-sectional sizes, the cross-sectional shapes, and the arrangement type of the plurality of nano-structures NP arranged in the first meta-region R1, the second meta-region R2, the third meta-region R3, and the fourth meta-region R4, the routing filter array 300 may separate and condense the green light, the blue light, the red light, and the infrared ray from the incident light. That is, the routing filter array 300 may condense, from the incident light, the green light onto the pixel corresponding to the first meta-region R1, the blue light onto the pixel corresponding to the second meta-region R2, the red light onto the pixel corresponding to the third meta-region R3, and the infrared ray onto the pixel corresponding to the fourth meta-region R4.

The light of different color bands separated by the routing filter array 300 may be separated into light of narrower wavelength bands by the unit filters of the spectral filter array 200 and then incident on the sensor substrate 100. Referring back to FIG. 2, the first unit filter 211 and the third unit filter 213 of the spectral filter array 200 may correspond to the first meta-region R1 of the routing filter array 300, and the second unit filter 212 and the fourth unit filter 214 of the spectral filter array 200 may correspond to the second meta-region R2 of the routing filter array 300. The first unit filter 211 and the third unit filter 213 may have different transmission spectrums, and the second unit filter 212 and the fourth unit filter 214 may have different transmission spectrums. Thus, the light having different wavelength bands may be incident on the first pixel 101, the second pixel 102, the third pixel 103, and the fourth pixel 104.

Although FIG. 2 shows only four (4) unit filters (e.g., the first to fourth unit filters 211 to 214), the present disclosure is not limited thereto. That is, the spectral filter array 200 may include four (4) or more unit filters.

FIG. 10 is a plan view showing an example of an arrangement of a plurality of unit filters in the spectral filter array 200 shown in FIG. 2. Referring to FIG. 10, the spectral filter array 200 may include a plurality of unit filters (e.g., a first unit filter F1, a second unit filter F2, a third unit filter F3, a fourth unit filter F4, a fifth unit filter F5, a sixth unit filter F6, a seventh unit filter F7, an eighth unit filter F8, a ninth unit filter F9, a tenth unit filter F10, an eleventh unit filter F11, a twelfth unit filter F12, thirteenth unit filter F13, a fourteenth unit filter F14, a fifteenth unit filter F15, and a sixteenth unit filter F16) that may be two-dimensionally (2D) arranged. FIG. 10 shows an example in which the spectral filter array 200 include first to sixteenth unit filters F1 to F16 that may be arranged in a 4×4 array. However, the present disclosure is not limited thereto, and the unit filters may be arranged in other various types. For example, the spectral filter array 200 may include nine (9) unit filters that are arranged in a 3×3 array, and/or 25 or more unit filters that may be arranged in a 5×5 array or greater. A size S of each of the plurality of unit filters F1 to F16 may be, for example, about 0.4 micrometers (μm) to about 100 μm, however, the present disclosure is not limited thereto.

In the example shown in FIG. 10, the first unit filter F1, the fifth unit filter F5, the ninth unit filter F9, and the thirteenth unit filter F13 may correspond to the first meta-region R1 of the routing filter array 300, the third unit filter F3, the seventh unit filter F7, the eleventh unit filter F11, and the fifteenth unit filter F15 may correspond to the second meta-region R2 of the routing filter array 300, the second unit filter F2, the sixth unit filter F6, the tenth unit filter F10, and fourteenth unit filter F14 may correspond to the third meta-region R3 of the routing filter array 300, and the fourth unit filter F4, the eighth unit filter F8, the twelfth unit filter F12, and the sixteenth unit filter F16 may correspond to the fourth meta-region R4 of the routing filter array 300. When the routing filter array 300 separately condenses the green light, the blue light, and the red light, the first unit filter F1, the fifth unit filter F5, the ninth unit filter F9, and the thirteenth unit filter F13, and the fourth unit filter F4, the eighth unit filter F8, the twelfth unit filter F12, and the sixteenth unit filter F16 may be configured to further separate the green light into narrower wavelength bands, the third unit filter F3, the seventh unit filter F7, the eleventh unit filter F11, and the fifteenth unit filter F15 may be configured to further separate the blue light into narrower wavelength bands, and the second unit filter F2, the sixth unit filter F6, the tenth unit filter F10, and fourteenth unit filter F14 may be configured to further separate the red light into narrower wavelength bands. Alternatively or additionally, when the routing filter array 300 separately condenses the green light, the blue light, the red light, and the infrared ray, the first unit filter F1, the fifth unit filter F5, the ninth unit filter F9, and the thirteenth unit filter F13 may further separate the green light into narrower wavelength bands, the third unit filter F3, the seventh unit filter F7, the eleventh unit filter F11, and the fifteenth unit filter F15 may further separate the blue light into narrower wavelength bands, the second unit filter F2, the sixth unit filter F6, the tenth unit filter F10, and fourteenth unit filter F14 may further separate the red light into narrower wavelength bands, and the fourth unit filter F4, the eighth unit filter F8, the twelfth unit filter F12, and the sixteenth unit filter F16 may further separate the infrared ray into narrower wavelength bands.

Each of the plurality of unit filters F1 to F16 in the spectral filter array 200 may be configured to have peak wavelengths of at least two wavelength bands (or at least two transmission peak wavelengths) in the transmission spectrum within a visible ray wavelength band (e.g., about 400 nm to about 750 nm) and/or infrared ray wavelength band (e.g., about 750 nm to about 1.4 μm). Through the combination of the routing filter array 300 and the spectral filter array 200, a channel array having, for example, sixteen (16) or more spectral channels, may be formed. The image sensor 1000 may sense the light having different peak wavelengths through the spectral channels and output image signals.

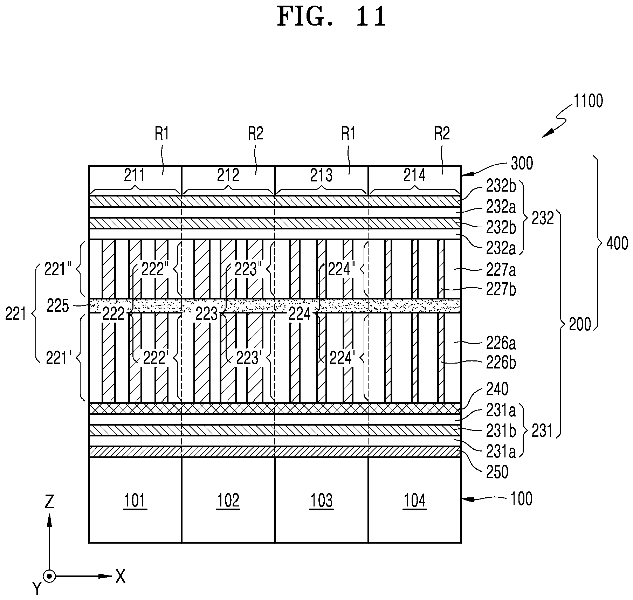

FIG. 11 is a cross-sectional view showing an example of a cross-sectional structure of spectral filters in the spectral filter array 200, according to an embodiment. Referring to FIG. 11, each of the first unit filter 211, the second unit filter 212, the third unit filter 213, and the fourth unit filter 214 may include a first reflector 231 and a second reflector 232 that may be provided spaced apart from each other. Additionally, the first unit filter 211, the second unit filter 212, the third unit filter 213, and the fourth unit filter 214 may respectively include a first cavity 221, a second cavity 222, a third cavity 223, and a fourth cavity 224 between the first reflector 231 and the second reflector 232.

The first and second reflectors 231 and 232 may each include a Bragg reflector. The Bragg reflector may include a distributed Bragg reflector (DBR) having a structure in which two or more dielectric materials having different refractive indexes may be alternately stacked. FIG. 11 shows an example, in which the first reflector 231 includes the Bragg reflector in which two dielectric materials 231a and 231b are alternately stacked, and the second reflector 232 includes the Bragg reflector in which two dielectric materials 232a and 232b are alternately stacked.

The first and second reflectors 231 and 232 may each include a metal reflector. The metal reflector may include, for example, aluminum (Al), argentum (Ag), gold (Au), copper (Cu), titanium (Ti), tungsten (W), titanium nitride (TiN), and the like. However, the present disclosure is not limited thereto. In addition, the first and second reflectors 231 and 232 may include different material layers. For example, the first reflector 231 may include the Bragg reflector and the second reflector 232 may include the metal reflector. However, the present disclosure is not limited to the above examples.

The first cavity 221, the second cavity 222, the third cavity 223, and the fourth cavity 224 may be provided between the first reflector 231 and the second reflector 232. The first to fourth cavities 221 to 224 may have the same thickness. Each of the first to fourth cavities 221 to 224 may have a transmission spectrum having at least two peak wavelengths (or transmission peak wavelengths) of different transmission wavelength bands within a visible ray wavelength band (e.g., from about 400 nm to about 750 nm) and/or an infrared ray wavelength band (e.g., from about 750 nm to about 1.4 μm). In an embodiment, each of the first to fourth cavities 221 to 224 may have a thickness of about 100 nm to about 2000 nm. For example, the first to fourth cavities 221 to 224 may each have a thickness of about 200 nm to about 1000 nm.

The first to fourth cavities 221 to 224 may respectively include cavity lower layers (e.g., first cavity lower layer 221', second cavity lower layer 222', third cavity lower layer 223', and fourth cavity lower layer 224') and cavity upper layers (e.g., first cavity upper layer 221", second cavity upper layer 222", third cavity upper layer 223", and fourth cavity upper layer 224"). The first to fourth cavities 221 to 224 may also further include a dielectric separation layer 225 disposed between the first to fourth cavity lower layers 221' to 224' and the first to fourth cavity upper layers 221" to 224". The first cavity 221 may include the first cavity lower layer 221', the dielectric separation layer 225, and the first cavity upper layer 221", the second cavity 222 may include the second cavity lower layer 222', the dielectric separation layer 225, and the second cavity upper layer 222", the third cavity 223 may include the third cavity lower layer 223', the dielectric separation layer 225, and the third cavity upper layer 223", and the fourth cavity 224 may include the fourth cavity lower layer 224', the dielectric separation layer 225, and the fourth cavity upper layer 224".

The first to fourth cavity lower layers 221' to 224' may have a substantially similar thickness and/or the same thickness, and the first to fourth cavity upper layers 221" to 224" may have a substantially similar thickness and/or the same thickness. That is, the first to fourth cavities 221 to 224 may have a substantially similar thickness and/or the same thickness. However, the present disclosure is not limited in this regard, and the first to fourth cavity lower layers 221' to 224' and the first to fourth cavity upper layers 221" to 224" may have different thicknesses or same thickness. FIG. 11 shows an example in which the first to fourth cavity upper layers 221" to 224" have less thickness than the first to fourth cavity lower layers 221' to 224', but the present disclosure is not limited thereto.

According to an embodiment, the first to fourth cavities 221 to 224 may be designed to have peak wavelengths of at least two different wavelength bands (or at least two transmission peak wavelengths) by adjusting a thickness and effective refractive index of each of the first to fourth cavity lower layers 221' to 224' and each of the first to fourth cavity upper layers 221" to 224".

Each of the first to fourth cavities 221 to 224 may include a certain dielectric pattern. The dielectric pattern of each of the first to fourth cavities 221 to 224 may include a lower dielectric pattern of the first to fourth cavity lower layers 221' to 224' and an upper dielectric pattern of the first to fourth cavity upper layers 221" to 224". That is, each of the first to fourth cavity lower layers 221' to 224' and the first to fourth cavity upper layers 221" to 224" may include one or more dielectric materials.

For example, each of the first to fourth cavity lower layers 221' to 224' may include a first dielectric material 226a and a second dielectric material 226b forming the lower dielectric pattern. The second dielectric material 226b may include a material having a second refractive index that may be greater than a first refractive index of the first dielectric material 226a. For example, the first dielectric material 226a may include, but not be limited to, silicon oxide (SiO₂) and the second dielectric material 226b may include, but not be limited to, titanium oxide (TiO₂). However, the present disclosure is not limited to these examples.

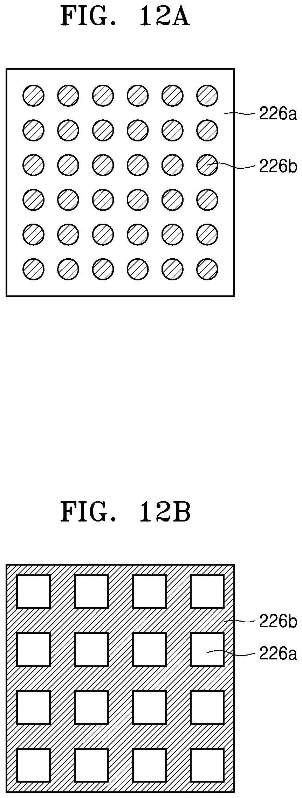

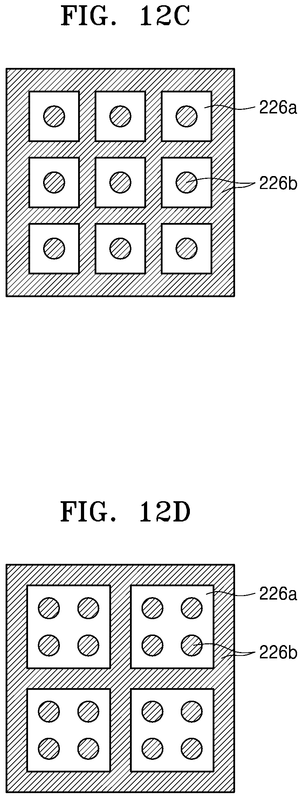

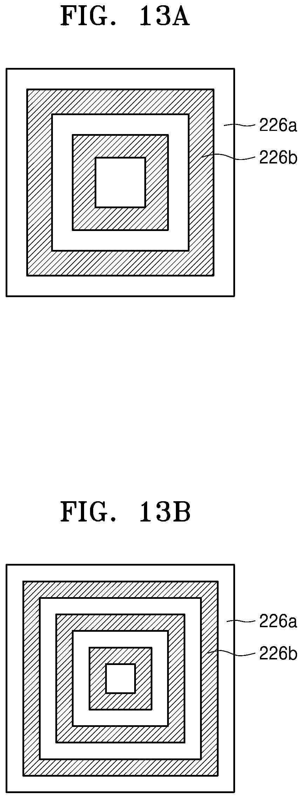

Each of the first to fourth cavity lower layers 221' to 224' may have various lower dielectric patterns according to materials, shapes, sizes, and arrangements of the first and second dielectric materials 226a and 226b. FIGS. 12A to 12D show examples of the lower dielectric pattern that may be applied to the first to fourth cavity lower layers 221' to 224' shown in FIG. 11. FIGS. 13A and 13B show additional examples of the lower dielectric pattern that may be applied to the first to fourth cavity lower layers 221' to 224' shown in FIG. 11.

The effective refractive index of the first to fourth cavity lower layers 221' to 224' may be adjusted by changing the lower dielectric patterns of the first to fourth cavity lower layers 221' to 224'. That is, the effective refractive index of the first to fourth cavity lower layers 221' to 224' may be determined according to a volume ratio of a volume occupied by the first dielectric material 226a with respect to a volume occupied by the second dielectric material 226b in each of the first to fourth cavity lower layers 221' to 224'. For example, as the volume ratio of the second dielectric material 226b increases in the first to fourth cavity lower layers 221' to 224', the effective refractive index of the cavity lower layers 221' to 224' may increase.

Each of the first to fourth cavity upper layers 221" to 224" may include a third dielectric material 227a and a fourth dielectric material 227b forming the upper dielectric pattern. A fourth refractive index of the fourth dielectric material 227b may be greater than a third refractive index of the third dielectric material 227a. That is, the third dielectric material 227a may include silicon oxide (SiO₂) and the fourth dielectric material 227b may include titanium oxide (TiO₂). However, the present disclosure is not limited to these examples.

Each of the first to fourth cavity upper layers 221" to 224" may have various types of upper dielectric patterns according to materials, shapes, sizes, and arrangement of the third and fourth dielectric materials 227a and 227b, similarly to the first to fourth cavity lower layers 221' to 224'. The effective refractive index of the first to fourth cavity upper layers 221" to 224" may be adjusted by changing the upper dielectric patterns of the first to fourth cavity upper layers 221" to 224". That is, the effective refractive index of the first to fourth cavity upper layers 221" to 224" may be determined according to a volume ratio of a volume occupied by the third dielectric material 227a with respect to a volume occupied by the fourth dielectric material 227b in each of the first to fourth cavity upper layers 221" to 224".

The lower dielectric pattern and the upper dielectric pattern forming the dielectric pattern of each of the first to fourth cavities 221 to 224 may be the same or different. FIG. 11 shows an example in which the lower dielectric pattern and the upper dielectric pattern forming the dielectric pattern of each of the first to fourth cavities 221 to 224 are the same as each other. In such an example, the effective refractive index of each of the first to fourth cavity lower layers 221' to 224' and the first to fourth cavity upper layers 221" to 224" may be adjusted by changing the volume ratio of the second and fourth dielectric materials 226b and 227b, and accordingly, the peak wavelength (or transmission peak wavelength) of the transmission spectrum of each of the first to fourth cavities 221 to 224 may be adjusted.

In the description above, an example in which each of the first to fourth cavity lower layers 221' to 224' and each of the first to fourth cavity upper layers 221" to 224" include two dielectric materials having different refractive indexes is described. However, the present disclosure not limited thereto, and the first to fourth cavity lower layers 221' to 224' and the first to fourth cavity upper layers 221" to 224" may each include only one (1) dielectric material or three (3) or more dielectric materials.

The dielectric separation layer 225 may be provided between the first to fourth cavity lower layers 221' to 224' and the first to fourth cavity upper layers 221" to 224". The dielectric separation layer 225 may be configured to have a refractive index that may be less than or equal to the maximum refractive index of the first to fourth cavity lower layers 221' to 224' and the first to fourth cavity upper layers 221" to 224". That is, the dielectric separation layer 225 may include a material having a refractive index that may be less than or equal to the second refractive index or the fourth refractive index that may be the largest refractive index from among the refractive indexes of the materials included in the first to fourth cavity lower layers 221' to 224' and the first to fourth cavity upper layers 221" to 224". For example, the dielectric separation layer 225 may include hafnium oxide ($HfO_2$) or titanium oxide ($TiO_2$), however, the present disclosure is not limited thereto. That is, when the first to fourth cavity lower layers 221' to 224' and the first to fourth cavity upper layers 221" to 224" include, but not be limited to, silicon oxide ($SiO_2$) or titanium oxide ($TiO_2$), the dielectric separation layer 225 may include, but not be limited to, titanium oxide ($TiO_2$) or hafnium oxide ($HfO_2$).

The dielectric separation layer 225 may be provided between the first to fourth cavity lower layers 221' to 224' and the first to fourth cavity upper layers 221" to 224" and may act as an etch stop layer. Accordingly, the manufacturing processes of the first to fourth cavities 221 to 224 may be simplified and reproductivity may be improved. In addition, the effective refractive index of each of the first to fourth cavity lower layers 221' to 224' and the first to fourth cavity upper layers 221" to 224" may be efficiently adjusted.

In an etching process for manufacturing one layer of cavity having relatively large thickness, the etched region may be formed to be inclined due to the large etching thickness, and thus, it may be difficult to precisely obtain desired patterns. In an embodiment, the first to fourth cavity lower layers 221' to 224' and the first to fourth cavity upper layers 221" to 224" included in the first to fourth cavities 221 to 224 may be separated by the dielectric separation layer 225 that may act as an etch stop layer, and thus, the first to fourth cavity lower layers 221' to 224' and the first to fourth cavity upper layers 221" to 224" may be formed through separate etching processes in the processes of manufacturing the first to fourth cavities 221 to 224. Accordingly, the etching processes for forming the first to fourth cavity lower layers 221' to 224' and the first to fourth cavity upper layers 221" to 224" may be easily performed, reproductivity may be improved, and the effective refractive index of each of the first to fourth cavity lower layers 221' to 224' and the first to fourth cavity upper layers 221" to 224" may be efficiently adjusted. The dielectric separation layer 225 may be formed to have various thickness according to the processing condition during the etching process. For example, the dielectric separation layer 225 may have a thickness of about 10 nm to about 100 nm, however, the present disclosure is not limited thereto.

In an embodiment, the image sensor 1000 may further include a passivation layer 250 disposed between the spectral filter array 200 and the sensor substrate 100 and/or an etch stop layer 240 disposed between the first reflector 231 and the first to fourth cavity lower layers 221' to 224'. The passivation layer 250 may protect the sensor substrate 100 during a process of providing the spectral filter array 200. The passivation layer 250 may include, for example, at least one of hafnium oxide ($HfO_2$), silicon oxide ($SiO_2$), and silicon nitride ($SiN$), however, the present disclosure is not limited thereto. The etch stop layer 240 may facilitate the patterning process for forming the first to fourth cavity lower layers 221' to 224'. The etch stop layer 240 may include, but is not limited to, a material having an etching speed that may be two (2) or more times (e.g., five (5) times) slower than that of the dielectric material forming the first to fourth cavity lower layers 221' to 224'. The etch stop layer 240 may include, for example, titanium oxide ($TiO_2$) or hafnium oxide ($HfO_2$), however,

the present disclosure is not limited thereto.

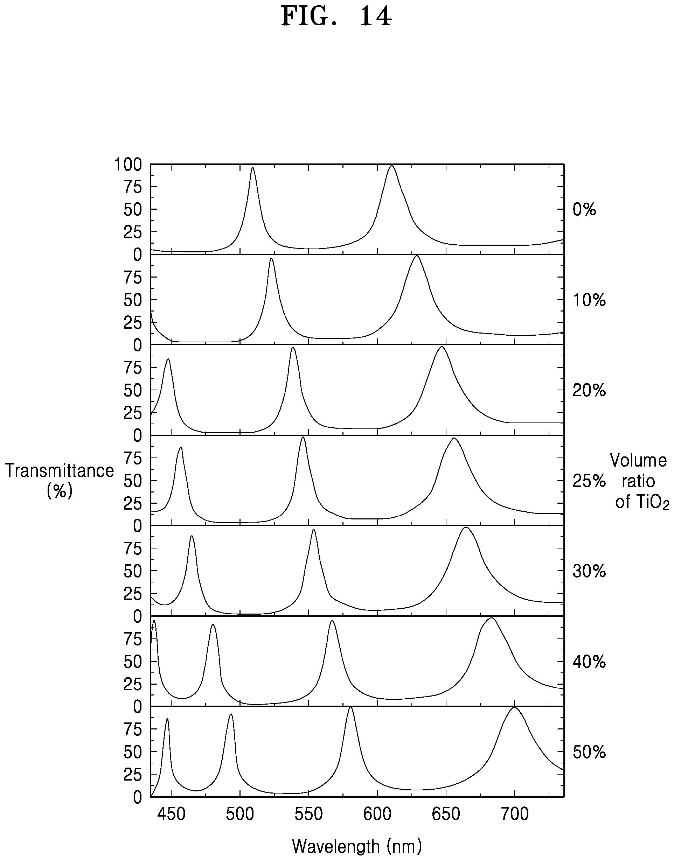

FIG. 14 shows a simulation result that shows examples of transmission spectrums of the first to fourth unit filters 211 to 214 of FIG. 11. In FIG. 14, the first and third dielectric materials 226a and 227a may include silicon oxide ($SiO_2$), and the second and fourth dielectric materials 226b and 227b may include titanium oxide ($TiO_2$). The first to fourth cavity lower layers 221' to 224' may be formed to have a thickness of about 230 nm, and the first to fourth cavity upper layers 221" to 224" may be formed to have a thickness of about 210 nm. FIG. 14 shows the transmission spectrums of the first to fourth cavities 221 to 224 when a volume ratio of the titanium oxide ($TiO_2$) is 0%, 10%, 20%, 25%, 30%, 40%, and 50%. Referring to FIG. 14, each of the first to fourth cavities 221 to 224 has a transmission spectrum having peak wavelengths of two or more different wavelength bands (or transmission peak wavelengths), and as the volume ratio of the titanium oxide ($TiO_2$) increases, the peak wavelengths (or transmission peak wavelengths) of the first to fourth unit filters 211 to 214 move in the increasing direction.

In the spectral filter 400, according to an embodiment, the routing filter array 300 may separate and condense the light of a relatively large wavelength band, and each of the first to fourth unit filters 211 to 214 of the spectral filter array 200 may have the transmission spectrum having at least two peak wavelengths of different wavelength bands that may be relatively narrow. That is, the transmission spectrum bandwidth of the routing filter array 300 may be greater than the transmission spectrum bandwidth of each of the first to fourth unit filters 211 to 214 of the spectral filter array 200. Accordingly, the plurality of spectral channels formed through combinations of the routing filter array 300 and the first to fourth unit filters 211 to 214 of the spectral filter array 200 may have the peak wavelengths of different transmission wavelength bands. For example, when each of the first to fourth unit filters 211 to 214 has the transmission spectrum having a peak wavelength of a red light wavelength band, a peak wavelength of a green light wavelength band, or a peak wavelength of a blue light wavelength band and the routing filter array 300 condenses green light onto the first unit filter 211, a first spectral channel formed by a combination of the routing filter array 300 and the first unit filter 211 may have a peak wavelength of the green light wavelength band. As another example, when the routing filter array 300 condenses blue light onto the second unit filter 112, a second spectral channel formed by a combination of the routing filter array 300 and the second unit filter 212 may have the peak wavelength of the blue light wavelength band.

When considering the wavelength bands separated by the routing filter array 300, at least two of the cavities in the unit filters (e.g., first to sixteenth unit filters F1 to F16 of FIG. 10) included in the spectral filter array 200 may be formed to have the same effective refractive index. That is, at least two of the cavities of the first to sixteenth unit filters F1 to F16 may be formed to have the same dielectric pattern (e.g., the lower dielectric pattern and the upper dielectric pattern). For example, when the routing filter array 300 separates and condenses the green light, the blue light, and the red light from the incident light and the transmission spectrum of each cavity in the spectral filter array 200 has the peak wavelength of the red light wavelength band, the peak wavelength of the green light wavelength band, and the peak wavelength of the blue light wavelength band, three cavities may have the same dielectric pattern and the combinations of the routing filter array 300 and three cavities may be configured to have different peak wavelengths.

In an embodiment, through the combinations of the routing filter array 300 and the first to sixteenth unit filters F1 to F16 of the spectral filter array 200, a channel array having N spectral channels (e.g., N = 16 channels) may be formed. In such an embodiment, the number of cavities having different effective refractive indexes (e.g., different lower dielectric patterns or different upper dielectric patterns) in the spectral filter array 200 may be less than that of the spectral channels. For example, when the routing filter array 300 separates and condenses light of A wavelength bands, the number N' of the cavities having different effective refractive indexes may satisfy the condition $\frac{N}{A} \leq N' < N$. For example, when the channel array has sixteen (16) channels and the routing filter array 300 separates and condenses light of three (3) wavelength bands, the number of cavities having different effective refractive indexes (e.g., different dielectric patterns) may be six (6) to fifteen (15).

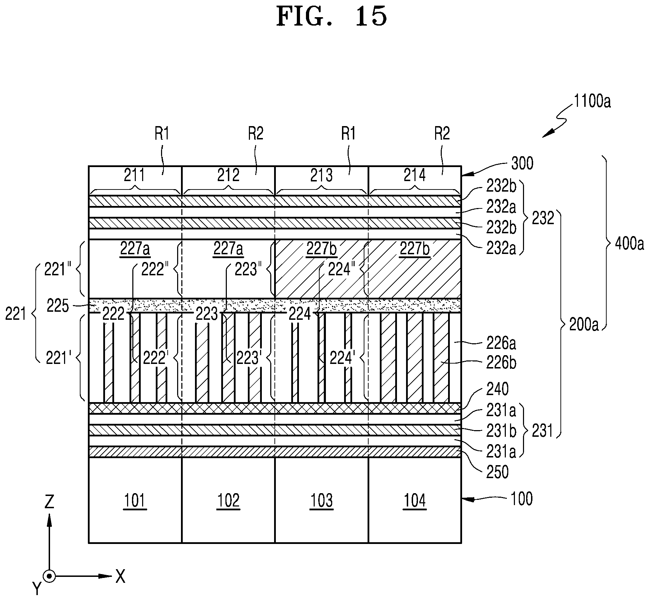

FIG. 15 is a cross-sectional view schematically showing a structure of a pixel array 1100a in the image sensor, according to an embodiment. The pixel array 1100a may include and/or may be similar in many respects to the pixel array 1100 described above with reference to FIGS. 2 to 14, and may include additional features not mentioned above. Consequently, repeated descriptions of the pixel array 1100a described above with reference to FIGS. 2 to 14 may be omitted for the sake of brevity.

Referring to FIG. 15, a spectral filter 400a of the pixel array 1100a may include the routing filter array 300, and a spectral filter array 200a provided between the sensor substrate 100 and the routing filter array 300. The routing filter array 300 may have the same configuration and functions as described above with reference to FIGS. 2 to 14.

Each of the first unit filter 211, the second unit filter 212, the third unit filter 213, and the fourth unit filter 214 of the spectral filter array 200a may include the first reflector 231 and the second reflector 232 that are provided spaced apart from each other. In addition, the first unit filter 211, the second unit filter 212, the third unit filter 213, and the fourth unit filter 214 may respectively include a first cavity 221, a second cavity 222, a third cavity 223, and a fourth cavity 224 between the first reflector 231 and the second reflector 232. The first to fourth cavities 221 to 224 may include the first to fourth cavity lower layers 221' to 224', the first to fourth cavity upper layers 221" to 224", and the dielectric separation layer 225 disposed between the cavity lower layers 221' to 224' and the cavity upper layers 221" to 224".

The first cavity 221 may include the first cavity lower layer 221', the dielectric separation layer 225, and the first cavity upper layer 221", the second cavity 222 may include the second cavity lower layer 222', the dielectric separation layer 225, and the second cavity upper layer 222", the third cavity 223 may include the third cavity lower layer 223', the dielectric separation layer 225, and the third cavity upper layer 223", and the fourth cavity 224 may include the fourth cavity lower layer 224', the dielectric separation layer 225, and the fourth cavity upper layer 224".

Each of the first to fourth cavities 221 to 224 may include a certain dielectric pattern. The dielectric pattern of each of the first to fourth cavities 221 to 224 may respectively include a lower dielectric pattern of the first to fourth cavity lower layers 221' to 224' and an upper dielectric pattern of the first to fourth cavity upper layers 221" to 224". FIG. 15 shows an example in which the lower dielectric pattern and the upper dielectric pattern on the lower dielectric pattern are different from each other.

Each of the first to fourth cavity lower layers 221' to 224' may include the first dielectric material 226a and the second dielectric material 226b. Each of the first to fourth cavity lower layers 221' to 224' may have various lower dielectric patterns according to materials, shapes, sizes, and arrangements of the first and second dielectric materials 226a and 226b. The effective refractive indexes of the first to fourth cavities 221 to 224 may be finely adjusted by changing a volume ratio occupied by the first and second dielectric materials 226a and 226b in each of the first to fourth cavity lower layers 221' to 224'.

Each of the first to fourth cavity upper layers 221" to 224" may include one dielectric substance. For example, the first and second cavity upper layers 221" and 222" may each include the third dielectric material 227a, and the third and fourth cavity upper layers 223" and 224" may each include the fourth dielectric material 227b. In an embodiment, the material in the fourth dielectric material 227b may have a refractive index that may be greater than that of the third dielectric material 227a. Each of the first to fourth cavity upper layers 221" to 224" may include only one dielectric substance, and thus, may largely adjust the effective refractive indexes of the first to fourth cavities 221 to 224 in comparison with the first to fourth cavity lower layers 221' to 224'.

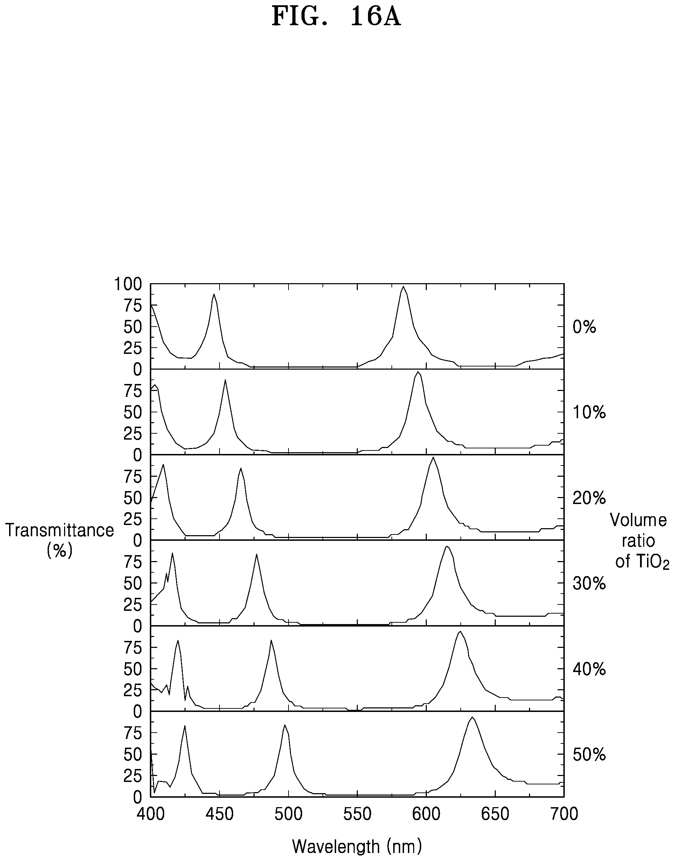

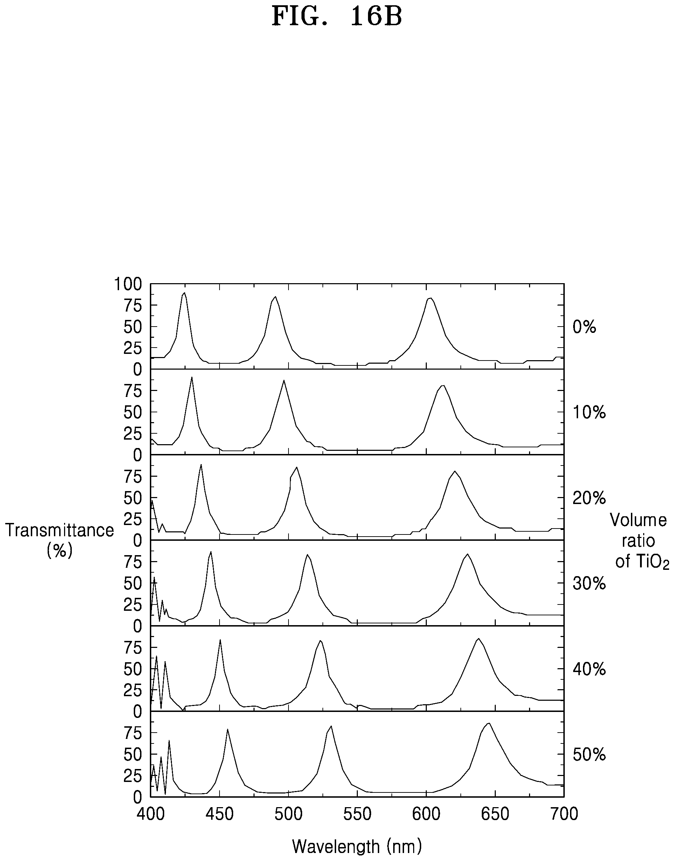

FIGS. 16A and 16B show simulation results that show examples of transmission spectrums of the first to fourth unit filters 211 to 214 of FIG. 15. For example, FIG. 16A shows the transmission spectrums of the first and second unit filters 211 and 212 shown in FIG. 15, and FIG.

16B shows the transmission spectrums of the third and fourth unit filters 213 and 214 shown in FIG. 15. In an example, the first and third dielectric materials 226a and 227a may include, but not be limited to, silicon oxide ($SiO_2$), and the second and fourth dielectric materials 226b and 227b may include, but not be limited to, titanium oxide ($TiO_2$). In an embodiment, the first to fourth cavity lower layers 221' to 224' may be formed to have a thickness of about 200 nm, and the first to fourth cavity upper layers 221" to 224" are formed to have a thickness of about 80 nm.

Referring to FIG. 16A, the transmission spectrums of the first and second unit filters 211 and 212 are shown, when the first and second cavity upper layers 221" and 222" include silicon oxide ($SiO_2$) and the volume ratio of the titanium oxide ($TiO_2$) in the first and second cavity lower layers 221' and 222' is 0%, 10%, 20%, 30%, 40%, and 50%. Referring to FIG. 16A, as the volume ratio of the titanium oxide ($TiO_2$) increases, the peak wavelengths (or transmission peak wavelengths) in the transmission spectrums of the first and second unit filters 211 and 212 may move in an increasing direction.

Referring to FIG. 16B, the transmission spectrums of the third and fourth unit filters 213 and 214 are shown, when the third and fourth cavity upper layers 223" and 224" include titanium oxide ($TiO_2$) and the volume ratio of the titanium oxide ($TiO_2$) in the third and fourth cavity lower layers 223' and 224' is 0%, 10%, 20%, 30%, 40%, and 50%. Referring to FIG. 16B, as the volume ratio of the titanium oxide ($TiO_2$) increases, the peak wavelengths (or transmission peak wavelengths) in the transmission spectrums of the third and fourth unit filters 213 and 214 may move in the increasing direction. Alternatively or additionally, because the third and fourth cavity upper layers 223" and 224" include titanium oxide ($TiO_2$), the transmission spectrums having peak wavelengths that are different from those of the example, in which the first and second cavity upper layers 221" and 222" include silicon oxide ($SiO_2$), as shown in FIG. 16A, may be obtained.

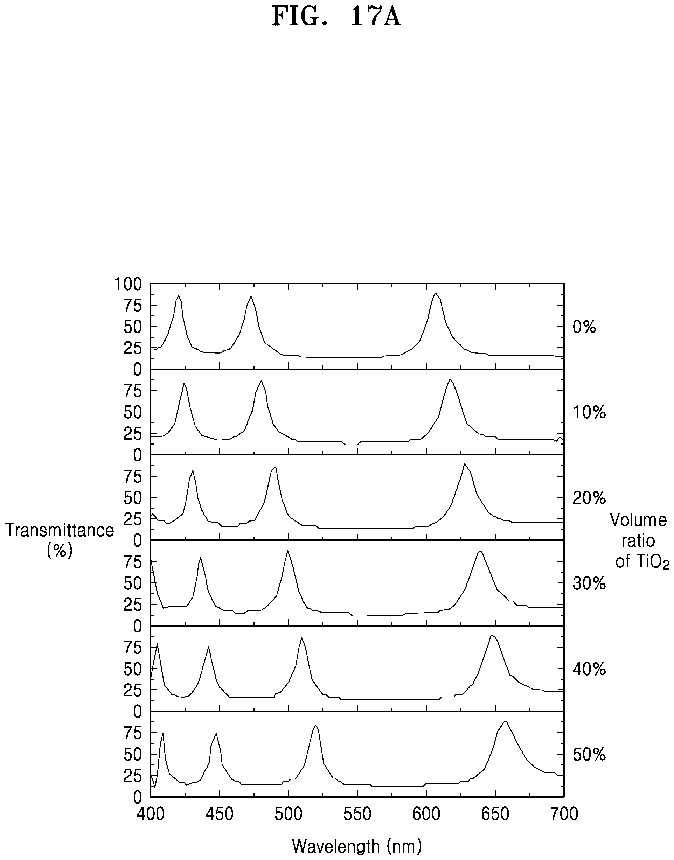

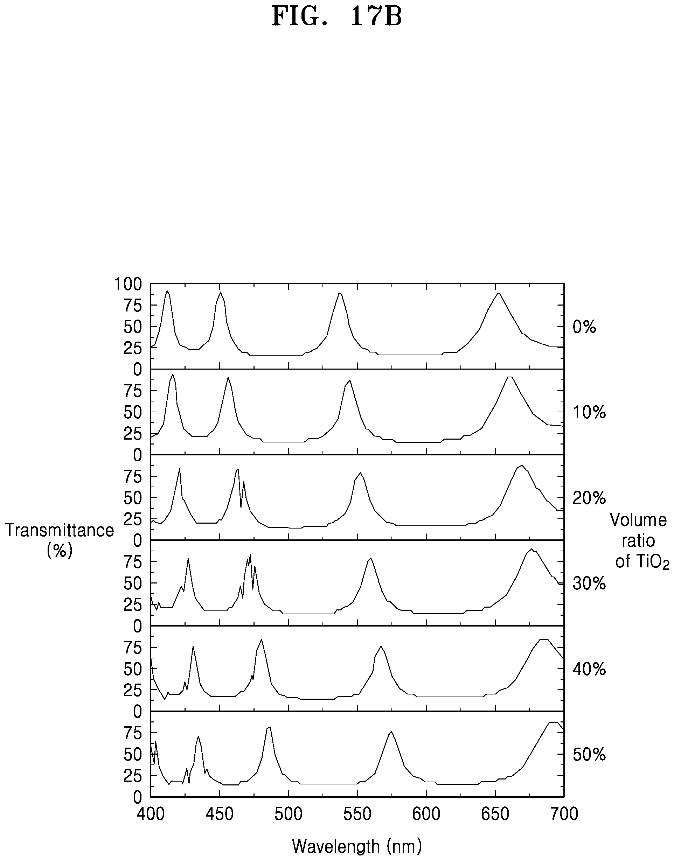

FIGS. 17A and 17B show other simulation results which show examples of transmission spectrums of the unit filters 211 to 214 of FIG. 15. FIG. 17A shows the transmission spectrums of the first and second unit filters 211 and 212, and FIG. 17B shows the transmission spectrums of the third and fourth unit filters 213 and 214. In an embodiment, the first and third dielectric materials 226a and 227a may include silicon oxide ($SiO_2$), and the second and fourth dielectric materials 226b and 227b may include titanium oxide ($TiO_2$). Alternatively or additionally, the first to fourth cavity lower layers 221' to 224' may be formed to have a thickness of about 200 nm, and the first to fourth cavity upper layers 221" to 224" may be formed to have a thickness of about 130 nm.

In FIG. 17A, when the first and second cavity upper layers 221" and 222" include silicon oxide ($SiO_2$) and the volume ratio of the titanium oxide ($TiO_2$) in the first

and second cavity lower layers 221' and 222' is 0%, 10%, 20%, 30%, 40%, and 50%, the transmission spectrums are shown. Referring to FIG. 17A, as the volume ratio of the titanium oxide ($TiO_2$) increases, the peak wavelengths (or transmission peak wavelengths) in the transmission spectrums of the first and second unit filters 211 and 212 may move in the increasing direction. In addition, because the first and second cavity upper layers 221" and 222" may be formed to have a thickness of about 130 nm, transmission spectrums having peak wavelengths that are different from those of the example, in which the first and second cavity upper layers 221" and 222" are formed to have the thickness of about 80 nm as shown in FIG. 16A, may be obtained.

FIG. 17B shows the transmission spectrums when the third and fourth cavity upper layers 223" and 224" include titanium oxide ($TiO_2$) and the volume ratio of the titanium oxide ($TiO_2$) in the third and fourth cavity lower layers 223' and 224' is 0%, 10%, 20%, 30%, 40%, and 50%. Referring to FIG. 17B, as the volume ratio of the titanium oxide ($TiO_2$) increases, the peak wavelengths (or transmission peak wavelengths) in the transmission spectrums of the third and fourth unit filters 213 and 214 may move in the increasing direction. In addition, because the third and fourth cavity upper layers 223" and 224" include titanium oxide ($TiO_2$), the transmission spectrums having peak wavelengths that are different from those of the example, in which the first and second cavity upper layers 221" and 222" include silicon oxide ($SiO_2$) as shown in FIG. 16A, may be obtained. When the third and fourth cavity upper layers 223" and 224" are formed to have the thickness of about 130 nm, the transmission spectrums having different peak wavelengths from those of the examples in which the third and fourth cavity upper layers 223" and 224" are formed to have the thickness of about 80 nm, as shown in FIG. 16B may be obtained.

As described above, the transmission spectrums having the peak wavelengths of different wavelength bands (or transmission peak wavelengths) may be obtained by adjusting the thickness and the effective refractive indexes of the first to fourth cavity lower layers 221' to 224' and the first to fourth cavity upper layers 221" to 224".

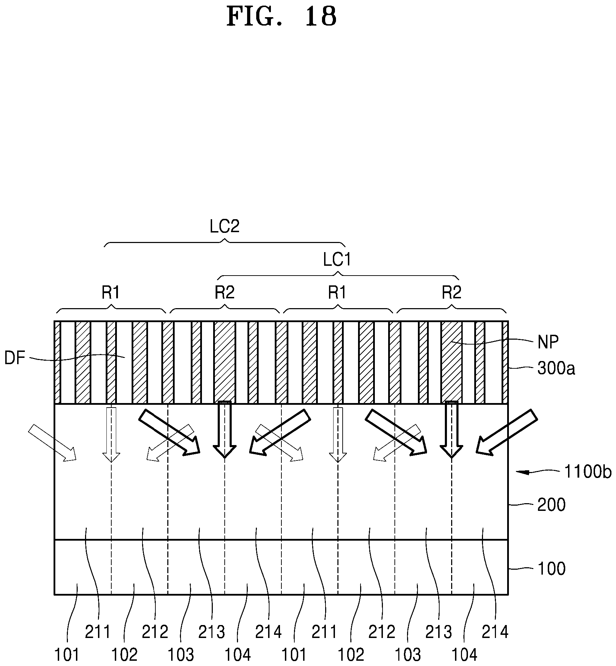

FIG. 18 is a cross-sectional view schematically showing a structure of a pixel array 1100b in an image sensor, according to an embodiment. The pixel array 1100b may include and/or may be similar in many respects to the pixel array 1100 and the pixel array 1100a described above with reference to FIGS. 2 to 17B, and may include additional features not mentioned above. Consequently, repeated descriptions of the pixel array 1100b described above with reference to FIGS. 2 to 17B may be omitted for the sake of brevity.

In the pixel array 1100 or 1100a described above, each of the first to fourth meta-regions R1 to R4 of the routing filter array 300 corresponds to one pixel of the sensor substrate 100 and one unit filter of the spectral filter array 200 or 200a. In the pixel array 1100b of the image sensor, as shown in FIG. 18, each of the first to fourth meta-regions R1 to R4 of a routing filter array 300a may correspond to four (4) pixels of the sensor substrate 100 and four (4) unit filters of the spectral filter array 200 or 200a. In the cross-sectional view of FIG. 18, two pixels (e.g., first pixel 101 and second pixel 102) and two unit filters (e.g., first unit filter 211 and second unit filter 212) corresponding to one first meta-region R1 are shown.

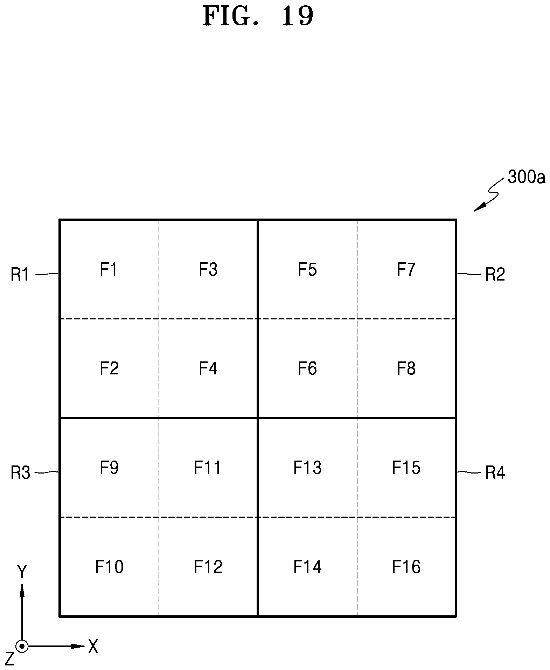

FIG. 19 is a plan view showing an example of a configuration in the routing filter array 300a shown in FIG. 18. Referring to FIG. 19, the first meta-region R1 corresponds to four (4) unit filters (e.g., first to fourth unit filters F1 to F4) arranged in a 2×2 array, the second meta-region R2 corresponds to four (4) unit filters (e.g., fifth to eighth unit filters F5 to F8) arranged in a 2×2 array, the third meta-region R3 corresponds to four (4) unit filters (e.g., ninth to twelfth unit filters F9 to F12) arranged in a 2×2 array, and the fourth meta-region R4 corresponds to four (4) unit filters (e.g., thirteenth to sixteenth unit filters F13 to F16) arranged in a 2×2 array. In an embodiment, each of the first to fourth meta-regions R1 to R4 may correspond to four (4) pixels arranged in a 2×2 array.

The configuration and functions of the routing filter array 300a may be the same as those of the routing filter array 300. For example, the routing filter array 300a may condense, in the incident light, the green light onto the four (4) pixels corresponding to the first meta-region R1 and the four (4) pixels corresponding to the fourth meta-region R4. As another example, the routing filter array 300a may condense, in the incident light, the blue light onto the four (4) pixels corresponding to the second meta-region R2 and the red light onto the four (4) pixels corresponding to the third meta-region R3. In such an example, the green light may be incident onto the four (4) unit filters (e.g., first to fourth unit filters F1 to F4) corresponding to the first meta-region R1 and the four (4) unit filters (e.g., thirteenth to sixteenth unit filters F13 to F16) corresponding to the fourth meta-region R4. The blue light is incident onto the four (4) unit filters (e.g., fifth to eighth unit filters F5 to F8) corresponding to the second meta-region R2 and the red light may be incident onto the four (4) unit filters (e.g., ninth to twelfth unit filters F9 to F12) corresponding to the third meta-region R3.

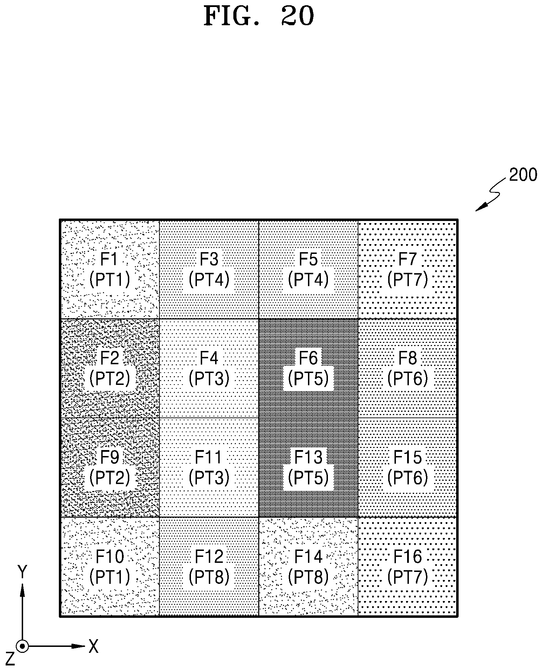

As described above, when the image sensor 1000 includes sixteen (16) spectral channels, all of the sixteen (16) unit filters of the spectral filter array 200 or 200a may not need to have different cavities. For example, the spectral filter array 200 or 200a may include six (6) to fifteen (15) kinds of cavities. That is, some of the unit filters of the spectral filter array 200 or 200a may have the same cavities. FIG. 20 is a plan view showing examples of different dielectric patterns respectively arranged in a plurality of unit filters of the spectral filter array 200 or 200a.

Referring to FIG. 20, the spectral filter array 200 may include first to sixteenth unit filters F1 to F16 including eight (8) different dielectric patterns (e.g., a first dielectric pattern PT1, a second dielectric pattern PT2, a third dielectric pattern PT3, a fourth dielectric pattern PT4, a fifth dielectric pattern PT5, a sixth dielectric pattern PT6, a seventh dielectric pattern PT7, and an eighth dielectric pattern PT8). For example, the cavities of the first unit filter F1 and the tenth unit filter F10 may have the first dielectric pattern PT1, the cavities of the second unit filter F2 and the ninth unit filter F9 may have the second dielectric pattern PT2, the cavities of the fourth unit filter F4 and the eleventh unit filter F11 may have the third dielectric pattern PT3, the cavities of the third unit filter F3 and the fifth unit filter F5 may have the fourth dielectric pattern PT4, the cavities of the sixth unit filter F6 and the thirteenth unit filter F13 may have the fifth dielectric pattern PT5, the cavities of the eighth unit filter F8 and the fifteenth unit filter F15 may have the sixth dielectric pattern PT6, the cavities of the seventh unit filter F7 and the sixteenth unit filter F16 may have the seventh dielectric pattern PT7, and the cavities of the twelfth unit filter F12 and the fourteenth unit filter F14 may have the eighth dielectric pattern PT8. The first to eighth dielectric patterns PT1 to PT8 may each have one of the transmission spectrums shown in, for example, FIGS. 14, 16A, 16B, 17A, or 17B.

As shown in FIG. 20, the first to fourth unit filters F1 to F4 corresponding to the first meta-region R1 may have different dielectric patterns (e.g., the first dielectric pattern PT1, the second dielectric pattern PT2, the fourth dielectric pattern PT4, and the third dielectric pattern PT3). Therefore, the light having further narrower peak wavelengths within the green light wavelength band may be incident on four (4) pixels corresponding to the first to fourth unit filters F1 to F4. The fifth to eighth unit filters F5 to F8 corresponding to the second meta-region R2 may have different dielectric patterns (e.g., the fourth dielectric pattern PT4, the fifth dielectric pattern PT5, the seventh dielectric pattern PT7, and the sixth dielectric pattern PT6), the ninth to the twelfth unit filters F9 to F12 corresponding to the third meta-region R3 may have different dielectric patterns (e.g., the second dielectric pattern PT2, the first dielectric pattern PT1, the third dielectric pattern PT3, and the eight dielectric pattern PT8), and the thirteenth to sixteenth unit filters F13 to F16 corresponding to the fourth meta-region R4 may have different dielectric patterns (e.g., the fifth dielectric pattern PT5, the eighth dielectric pattern PT8, the sixth dielectric pattern PT6, and the seventh dielectric pattern PT7). Therefore, the light having further narrower different peak wavelengths within the blue light wavelength band may be incident on four (4) pixels respectively corresponding to the fifth to eighth unit filters F5 to F8, the light having further narrower different peak wavelengths within the red light wavelength band may be incident on four (4) pixels respectively corresponding to the ninth to twelfth unit filters F9 to F12, and the light having further narrower different peak wavelengths within the green light wavelength band may be incident on four (4) pixels respectively corresponding to the thirteenth to sixteenth unit filters F13 to F16. Alternatively or additionally, the eight unit filters (e.g., the first unit filter F1, the second unit filter F2, the third unit filter F3, the fourth unit filter F4, the thirteenth unit filter F13, the fourteenth unit filter F14, the fifteenth unit filter F15, and the sixteenth F16) corresponding to the first and fourth meta-regions R1 and R4 may have different dielectric patterns (e.g., the first dielectric pattern PT1, the second dielectric pattern PT2, the fourth dielectric pattern PT4, the third dielectric pattern PT3, the fifth dielectric pattern PT5, the eighth dielectric pattern PT8, the sixth dielectric pattern PT6, and the seventh dielectric pattern PT7).

In another example, the routing filter array 300a may condense, from the incident light, the green light onto the pixel corresponding to the first meta-region R1, the blue light onto the pixel corresponding to the second meta-region R2, the red light onto the pixel corresponding to the third meta-region R3, and the infrared ray onto the pixel corresponding to the fourth meta-region R4. Consequently, the infrared ray may be incident on the four (4) unit filters (e.g., the thirteenth unit filter F13, the fourteenth unit filter F14, the fifteenth unit filter F15, and the sixteenth unit filter F16) corresponding to the fourth meta-region R4. Thus, some of the four (4) unit filters (e.g., the first unit filter F1, the second unit filter F2, the third unit filter F3, and the fourth unit filter F4) corresponding to the first meta-region R1 and some of the four (4) unit filters (e.g., the thirteenth unit filter F13, the fourteenth unit filter F14, the fifteenth unit filter F15, and the sixteenth unit filter F16) corresponding to the fourth meta-region R4 may have the same dielectric patterns.

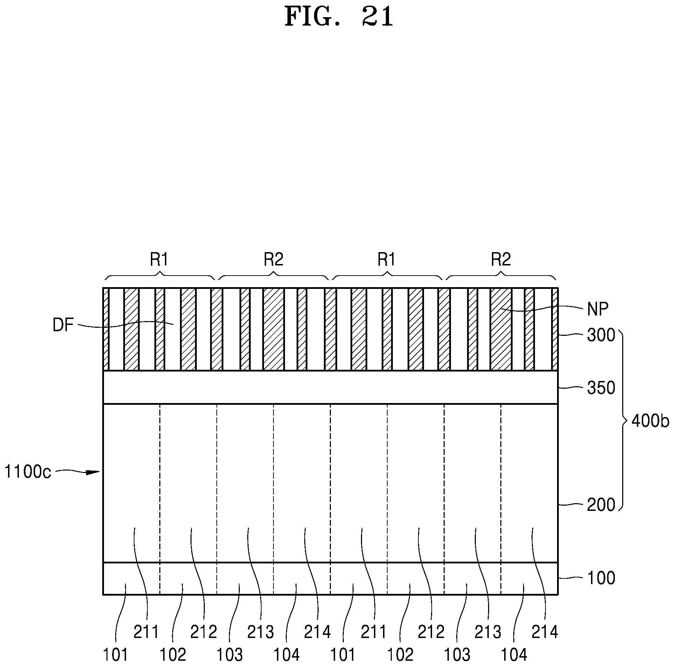

FIG. 21 is a cross-sectional view schematically showing a structure of a pixel array 1100c in an image sensor, according to an embodiment. The pixel array 1100c may include and/or may be similar in many respects to the pixel arrays 1100, 1100a, and 1100b described above with reference to FIGS. 2 to 20, and may include additional features not mentioned above. Consequently, repeated descriptions of the pixel array 1100c described above with reference to FIGS. 2 to 20 may be omitted for the sake of brevity.

Referring to FIG. 21, a spectral filter 400b of the pixel array 1100c may further include a spacer layer 350 disposed between the spectral filter array 200 and the routing filter array 300. The spacer layer 350 may have a function of securing a distance between the sensor substrate 100 and the routing filter array 300 such that the light separated by the routing filter array 300 may be optimally condensed on the sensor substrate 100. Alternatively or additionally, the spacer layer 350 may maintain the distance between the sensor substrate 100 and the routing filter array 300. The spacer layer 350 may include a dielectric material having a low absorption ratio in a visible or infrared ray band while having lower refractive index than the nano-structures NP. For example, the spacer layer 350 may include at least one of silicon oxide ($SiO_2$), aluminum oxide ($Al_2O_3$), silicon nitride

(SiN), and silicon oxynitride (SiON). The thickness of the spacer layer 350 may be set such that a focusing spot may be formed on the sensor substrate 100 in consideration of the focal length of light condensed by the routing filter array 300. For example, the maximum thickness of the spacer layer 350 may be less than or equal to about 1 μm.

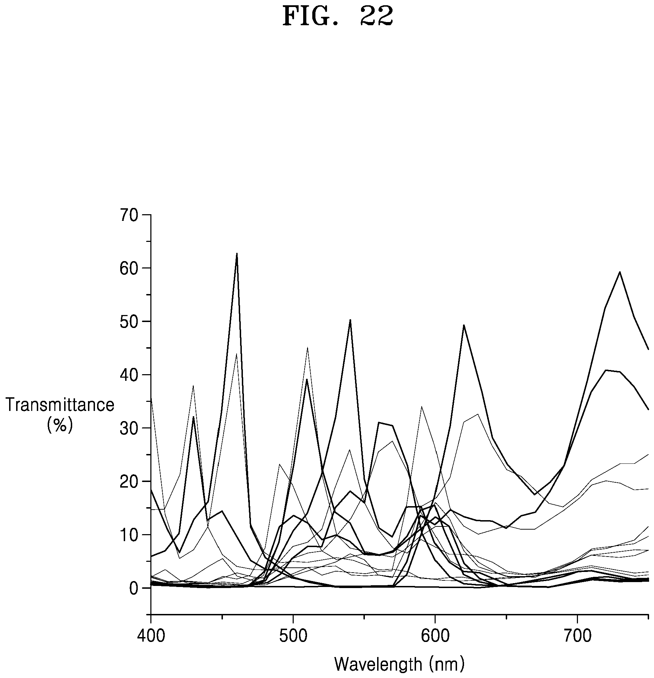

FIG. 22 is a graph showing a difference in a light utilization efficiency between an image sensor using the routing filter array 300, according to an embodiment, and a related image sensor using a general red-green-blue (RGB) filter array. In FIG. 22, thick solid lines denote examples of the transmission spectrums of light reaching the pixels in the plurality of spectral channels of the image sensor according to the present disclosure, and thin solid lines denote examples of transmission spectrums of the light reaching the pixels in a plurality of spectral channels of the related image sensor. Referring to FIG. 22, intensities of the light reaching the pixels in the plurality of spectral channels of the image sensor according to the present disclosure are generally greater than those of the light reaching the pixels in the plurality of spectral channels of the related image sensor. The above result may occur based on the absorption loss being relatively small when the routing filter array 300 is used, whereas only about a third (e.g., ⅓) of the incident light passes through the color filter array and about two-thirds (e.g., ⅔) of the incident light is absorbed when a general RGB color filter array is used.

The image sensor 1000 including the spectral filter may be employed in various high-performance optical devices or high-performance electronic apparatuses. The electronic apparatuses may include, for example, but not be limited to, smartphones, mobile phones, cell phones, personal digital assistants (PDAs), laptop computers, personal computers (PCs), a variety of portable devices, electronic apparatuses, surveillance cameras, medical camera, automobiles, Internet of Things (IoT) devices, other mobile or non-mobile computing devices, and the like. The present disclosure is not limited thereto.

The electronic apparatuses may further include, in addition to the image sensor 1000, a processor for controlling the image sensor 1000, such as, but not limited to, an application processor (AP), and may control a plurality of hardware and/or software elements and may perform various data processes and operations by driving an operation system or application programs via the processor. The processor may further include a graphic processing unit (GPU) and/or an image signal processor. When an image signal processor is included in the processor, an image (and/or video) obtained by the image sensor may be stored and/or output by using the processor.

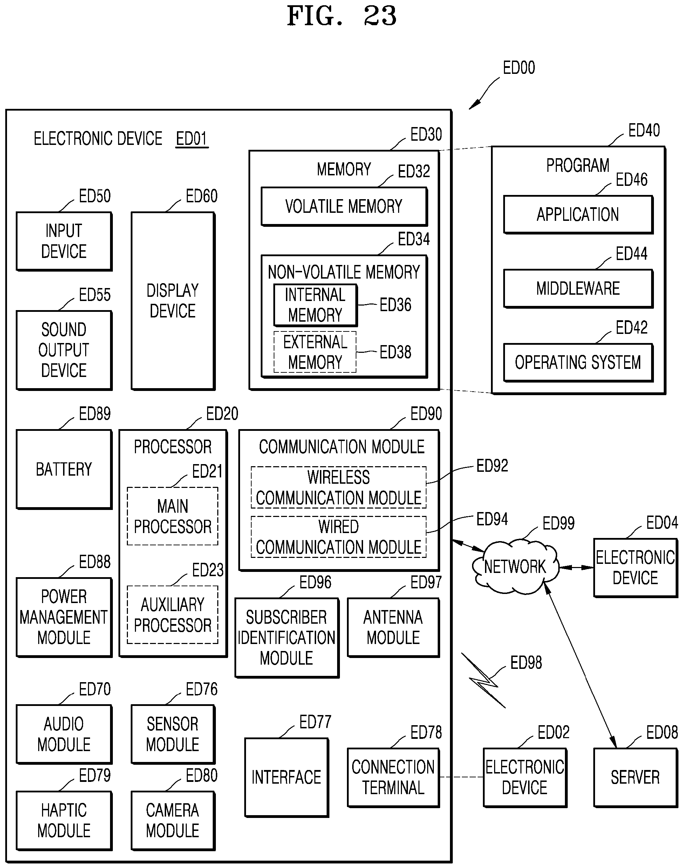

FIG. 23 is a block diagram showing an example of an electronic apparatus ED01 including an image sensor 1000. Referring to FIG. 23, in a network environment ED00, the electronic apparatus ED01 may communicate with another electronic apparatus ED02 via a first network ED98 (e.g., short-range wireless communication network, and the like), and/or may communicate with another electronic apparatus ED04 and/or a server ED08 via a second network ED99 (e.g., long-range wireless communication network, and the like) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some of the elements (e.g., the display device ED60, and the like) may be omitted and/or another element may be added. Some of the elements may be configured as one integrated circuit. For example, the sensor module ED76 (e.g., a fingerprint sensor, an iris sensor, an illuminance sensor, and the like) may be embedded and implemented in the display device ED60 (e.g., display, and the like). When the image sensor 1000 includes a spectral function, some of the functions (e.g., color sensor, illuminance sensor, and the like) of the sensor module ED76 may be implemented by the image sensor 1000 itself, not by a separate sensor module.

The processor ED20 may control one or more elements (e.g., hardware, software elements, and the like) of the electronic apparatus ED01 connected to the processor ED20 by executing software (e.g., program ED40, and the like), and may perform various data processes or operations. As a part of the data processing or operations, the processor ED20 may load a command and/or data received from another element (e.g., sensor module ED76, communication module ED90, and the like) to a volatile memory ED32, may process the command and/or data stored in the volatile memory ED32, and may store result data in a non-volatile memory ED34. The non-volatile memory ED34 may include an internal memory ED36 and an external memory ED38. The processor ED20 may include a main processor ED21 (e.g., a central processing unit, an application processor, and the like) and an auxiliary processor ED23 (e.g., graphic processing unit, image signal processor, sensor hub processor, communication processor, and the like) that may be operated independently from and/or along with the main processor ED21. The auxiliary processor ED23 may use less power than that of the main processor ED21, and may perform specified functions.

The auxiliary processor ED23, on behalf of the main processor ED21 while the main processor ED21 is in an inactive state (sleep state) or along with the main processor ED21 while the main processor ED21 is in an active state (application execution state), may control functions and/or states related to some of the elements (e.g., display device ED60, sensor module ED76, communication module ED90, and the like) in the electronic apparatus ED01. The auxiliary processor ED23 (e.g., image signal processor, communication processor, and the like) may be implemented as a part of another element (e.g., camera module ED80, communication module ED90, and the like) that may be functionally related thereto.

The memory ED30 may store various data required by the elements (e.g., processor ED20, sensor module ED76, and the like) of the electronic apparatus ED01. The data may include, for example, input data and/or output data about software (e.g., program ED40, and the like) and commands related thereto. The memory ED30 may include the volatile memory ED32 and/or the non-volatile memory ED34.

The program ED40 may be stored as software in the memory ED30, and may include an operation system ED42, middleware ED44, and/or an application ED46.

The input device ED50 may receive commands and/or data to be used in the elements (e.g., processor ED20, and the like) of the electronic apparatus ED01, from outside (e.g., user, and the like) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker and/or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include a touch circuitry set to sense a touch, and/or a sensor circuit (e.g., pressure sensor, and the like) that is set to measure a strength of a force generated by the touch.

The audio module ED70 may convert sound into an electrical signal and/or may convert an electrical signal into sound. The audio module ED 70 may acquire sound through the input device ED50, or may output sound via the sound output device ED55, a speaker, and/or a headphone of another electronic apparatus (e.g., electronic apparatus ED02, and the like) connected directly and/or wirelessly to the electronic apparatus ED01.

The sensor module ED76 may sense an operating state (e.g., power, temperature, and the like) of the electronic apparatus ED01, or an outer environmental state (e.g., user state, and the like), and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly (wired) and/or wirelessly connected to another electronic apparatus (e.g., electronic apparatus ED02, and the like). The interface ED77 may include a high-definition multimedia interface (HDMI), a universal serial bus (USB) interface, a Secure Digital (SD) card interface, and/or an audio interface.

The connection terminal ED78 may include a connector by which the electronic apparatus ED01 may be physically connected to another electronic apparatus (e.g., electronic apparatus ED02, and the like). The connection terminal ED78 may include an HDMI connector, a USB connector, an SD card connector, and/or an audio connector (e.g., headphone connector, and the like).

The haptic module ED79 may convert the electrical signal into a mechanical stimulation (e.g., vibration, motion, and the like) or an electric stimulation that the user may sense through a tactile or motion sensation. The haptic module ED79 may include a motor, a piezoelectric device, and/or an electric stimulus device.

The camera module ED80 may capture a still image and/or a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell. However, the present disclosure is not limited in this regard, and the battery ED89 may include other types of batteries and/or combinations of batteries.

The communication module ED90 may support the establishment of a direct (wired) communication channel and/or a wireless communication channel between the electronic apparatus ED01 and another electronic apparatus (e.g., electronic apparatus ED02, electronic apparatus ED04, server ED08, and the like), and execution of communication through the established communication channel. The communication module ED90 may be operated independently from the processor ED20 (e.g., an application processor, and the like), and may include one or more communication processors that support the direct communication and/or the wireless communication. The communication module ED90 may include a wireless communication module ED92 (e.g., cellular communication module, a short-range wireless communication module, a global navigation satellite system (GNSS) communication module) and/or a wired communication module ED94 (e.g., local area network (LAN) communication module, a power line communication module, and the like). From among the communication modules, a corresponding communication module may communicate with another electronic apparatus via a first network ED98 (e.g., a short-range communication network such as, but not limited to, Bluetooth™, Wi-Fi based on the Institute of Electrical and Electronics Engineers (IEEE 802.11) standard (e.g., Wi-Fi direct), or Infrared Data Association (IrDA)) or a second network ED99 (long-range communication network such as a cellular network, Internet, or computer network (e.g., LAN, wide area network (WAN), and the like)). The various kinds of communication modules may be integrated as one element (e.g., a single chip, and the like) or may be implemented as a plurality of elements (e.g., a plurality of chips) separately from one another. The wireless communication module ED92 may identify and authenticate the electronic apparatus ED01 in a communication network such as the first network ED98 and/or the second network ED99 by using subscriber information (e.g., international mobile subscriber identifier (IMSI), and the like) stored in the subscriber identification module ED96.

The antenna module ED97 may transmit and/or receive a signal and/or power to/from outside (e.g., another electronic apparatus, and the like). An antenna may include a radiator formed as a conductive pattern formed on a substrate (e.g., printed circuit board (PCB, and the like)). The antenna module ED97 may include one or more antennas. When the antenna module ED97 includes a plurality of antennas, an antenna that may be suitable for the communication type used in the communication network, such as the first network ED98 and/or the second network ED99, may be selected from among the plurality of antennas by the communication module ED90. The signal and/or the power may be transmitted between the communication module ED90 and another electronic apparatus via the selected antenna. Another component (e.g., a radio-frequency integrated circuit (RFIC), and the like) other than the antenna may be included as a part of the antenna module ED97.

Some of the elements may be connected to one another via the communication method among the peripheral devices (e.g., bus, general purpose input and output (GPIO), serial peripheral interface (SPI), mobile industry processor interface (MIPI), and the like) and may exchange signals (e.g., commands, data, and the like).

The command and/or data may be transmitted and/or received between the electronic apparatus ED01 and the external electronic apparatus ED04 via the server ED08 connected to the second network ED99. Other electronic apparatuses ED02 and ED04 may be and/or may include devices that may be substantially similar and/or the same as the electronic apparatus ED01. However, the present disclosure is not limited in this regard, and electronic apparatuses ED02 and ED04 may be different kinds of devices from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function and/or service, the electronic apparatus ED01 may request one or more other electronic apparatuses to perform some and/or an entire function and/or service, instead of executing the function and/or service by itself. One or more electronic apparatuses receiving the request may execute an additional function and/or service related to the request and may transfer a result of the execution to the electronic apparatus ED01. For example, a cloud computing, a distributed computing, or a client-server computing technique may be used.

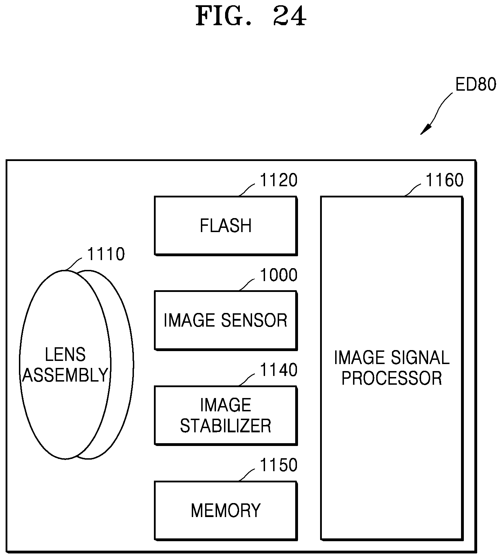

FIG. 24 is a block diagram showing an example of the camera module ED80 included in the electronic apparatus ED01 of FIG. 23. Referring to FIG. 24, the camera module ED80 may include a lens assembly 1110, a flash 1120, an image sensor 1000, an image stabilizer 1140, a memory 1150 (e.g., buffer memory, and the like), and/or an image signal processor 1160. The lens assembly 1110 may collect light emitted from an object that is to be captured. The camera module ED80 may include a plurality of lens assemblies 1110. For example, the camera module ED80 may be and/or may include a dual camera module, a 360-degree camera, a spherical camera, or the like. Some of the plurality of lens assemblies 1110 may have the same lens properties (e.g., viewing angle, focal length, auto-focus, F number, optical zoom, and the like) and/or different lens properties. The lens assembly 1110 may include, but not be limited to, a wide-angle lens, a telephoto lens, or the like.

The flash 1120 may emit light that may be used to strengthen the light emitted and/or reflected from the object. The flash 1120 may emit visible light, infrared (IR) ray light, or the like. The flash 1120 may include one or more light-emitting diodes (LEDs) (e.g., RGB LED, white LED, infrared LED, ultraviolet LED, and the like), and/or a Xenon lamp. The image sensor 1000 may include and/or may be similar in many respects to the image sensor described above with reference to FIG. 1, and may include additional features not mentioned above. The image sensors 1000 may convert the light emitted and/or reflected from the object and transferred through the lens assembly 1110 into an electrical signal to obtain an image corresponding to the object.

The image stabilizer 1140, in response to a motion of the camera module ED80 and/or the electronic apparatus ED01 including the camera module ED80, may move one or more lenses included in the lens assembly 1110 and/or the image sensor 1000 in a certain direction and/or may control the operating characteristics of the image sensor 1000 (e.g., adjusting of a read-out timing, and the like) in order to compensate for a negative influence of the motion. The image stabilizer 1140 may sense the movement of the camera module ED80 and/or the electronic apparatus ED01 by using a gyro sensor and/or an acceleration sensor disposed in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (e.g., Bayer-patterned data, high-resolution data, and the like) may be stored in the memory 1150, and only a low-resolution image may be displayed. Subsequently, original data of a selected image (e.g., due to user selection, and the like) may be transferred to the image signal processor 1160. The memory 1150 may be integrated with the memory ED30 of the electronic apparatus ED01, and/or may include an additional memory that is operated independently.

The image signal processor 1160 may perform image treatment on the image obtained through the image sensor 1000 and/or the image data stored in the memory 1150. The image treatments may include a depth map generation, a three-dimensional (3D) modeling, a panorama generation, extraction of features, an image combination, and/or an image compensation (e.g., noise reduction, resolution adjustment, brightness adjustment, blurring, sharpening, softening, and the like). The image signal processor 1160 may perform controlling (e.g., exposure time control, read-out timing control, and the like) of the elements (e.g., image sensor 1000, and the like) included in the camera module ED80. In an embodiment, the image signal processor 1160 may generate a full-color image by executing a demosaic algorithm. For example, when the demosaic algorithm is executed to generate the full-color image, the image signal processor 1160 may reconstruct most of the spatial resolution information by using an image signal of a green channel or yellow channel having high spatial sampling rate.

The image processed by the image signal processor 1160 may be stored again in the memory 1150 for additional process, and/or may be provided to an external element of the camera module ED80 (e.g., the memory ED30, the display device ED60, the electronic apparatus ED02, the electronic apparatus ED04, the server ED08, and the like). The image signal processor 1160 may be integrated with the processor ED20, and/or may be configured as an additional processor that may be independently operated from the processor ED20. When the image signal processor 1160 is configured as an additional processor separately from the processor ED20, the image processed by the image signal processor 1160 may go through an additional image treatment by the processor ED20 and then may be displayed on the display device ED60.

In an embodiment, the image signal processor 1160 may receive two output signals independently from the adjacent photosensitive cells in each pixel and/or sub-pixel of the image sensor 1000, and may generate an auto-focusing signal from a difference between the two output signals. The image signal processor 1160 may control the lens assembly 1110 such that the focus of the lens assembly 1110 may be accurately formed on the surface of the image sensor 1000 based on the auto-focusing signal.

The electronic apparatus ED01 may further include one or a plurality of camera modules having different properties and/or functions. The camera module may include elements similar to those of the camera module ED80 of FIG. 24, and the image sensor included in the camera module may be implemented as a CCD sensor and/or a CMOS sensor and may include one or a plurality of sensors selected from the image sensors having different properties, such as, but not limited to, an RGB sensor, a black and white (BW) sensor, an IR sensor, or an ultraviolet (UV) sensor. For example, one of the plurality of camera modules ED80 may include a wide-angle camera and another camera module ED80 may include a telephoto camera. Similarly, one of the plurality of camera modules ED80 may include a front camera and another camera module ED80 may include a rear camera. Also, the camera module ED80 may be a combination-type camera module, in which an image sensor having a general RGB three-color filter and a spectral image sensor including a spectral filter are combined and data from two image sensors combined together is integrally processed.

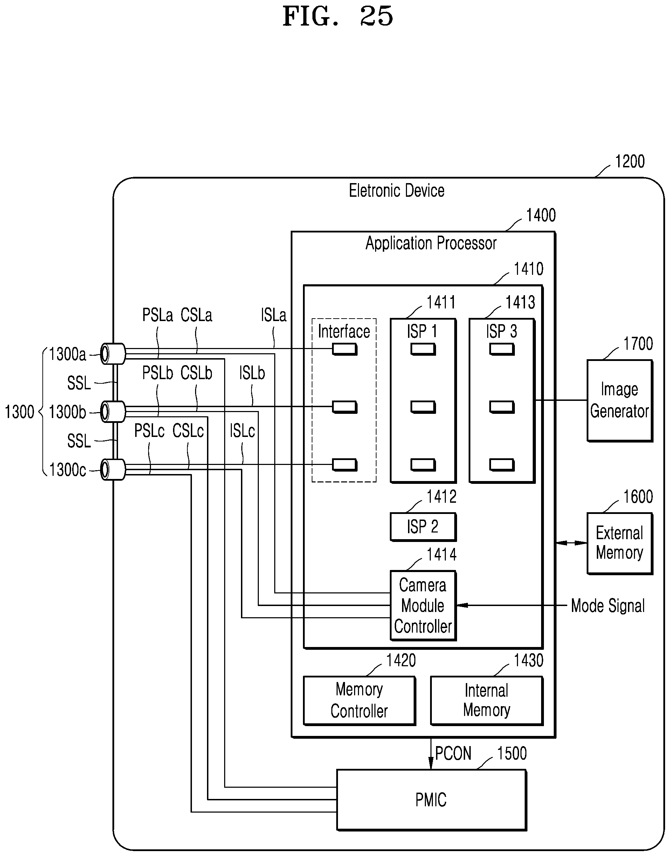

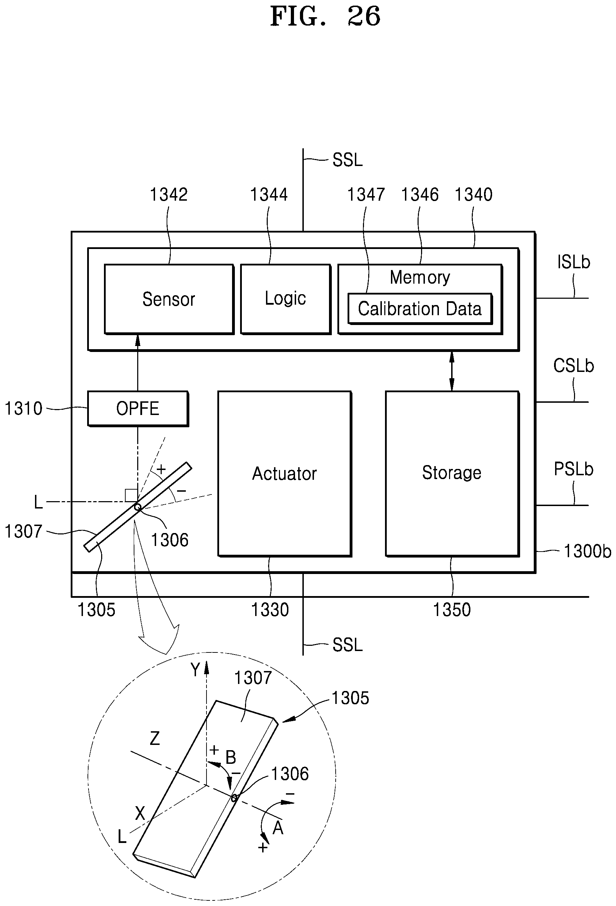

FIG. 25 is a block diagram of an electronic device 1200 including a multi-camera module, according to an embodiment. FIG. 26 is a detailed block diagram of the camera module in the electronic device shown in FIG. 25, according to an embodiment.

Referring to FIG. 25, the electronic device 1200 may include a camera module group 1300, an application processor 1400, a power management integrated circuit (PMIC) 1500, an external memory 1600, and an image generator 1700.

The camera module group 1300 may include a plurality of camera modules (e.g., first camera module 1300a, second camera module 1300b, and third camera module 1300c). Although the drawings show an example in which three (3) camera modules 1300a to 1300c are arranged, the present disclosure is not limited thereto. In some embodiments, the camera module group 1300 may be modified to include only two (2) camera modules. Also, in some embodiments, the camera module group 1300 may be modified to include four (4) or more camera modules.

Hereinafter, detailed configuration of the second camera module 1300b is described below with reference to FIG. 26, but the description provided below may be also applied to the other camera modules (e.g., the first camera module 1300a and the third camera module 1300c), according to the embodiments.

Referring to FIG. 26, the second camera module 1300b may include a prism 1305, an optical path folding element (OPFE) 1310, an actuator 1330, an image sensing device 1340, and a storage unit 1350.

The prism 1305 may include a reflecting surface 1307 having a light-reflecting material and may deform a path of light L incident from outside.

In some embodiments, the prism 1305 may change the path of the light L incident in the first direction (X-direction) into a second direction (Y-direction) that is perpendicular to the first direction (X-direction). The prism 1305 may rotate the reflecting surface 1307 having the light-reflecting material about a center axis 1306 in a direction A, or about the center axis 1306 in a direction B such that the path of the light L incident in the first direction (X-direction) may be changed to the second direction (Y-direction) perpendicular to the first direction (X-direction). The OPFE 1310 may also move in the third direction (Z-direction) that is perpendicular to the first direction (X-direction) and the second direction (Y-direction).

In some embodiments, as shown in the drawings, the maximum rotation angle of the prism 1305 in the direction A is 15° or less in the positive A direction and is greater than 15° in the negative A direction, but the present disclosure is not limited thereto.

In some embodiments, the prism 1305 may be moved by the angle of about 20°, between about 10° to about 20°, or between about 15° to about 20° in the positive or negative B direction. As used herein, the moving angle may be the same in the positive or negative B direction, and/or may be substantially similar within a range of about 1°.

In some embodiments, the prism 1305 may move the reflecting surface 1307 of the light-reflective material in the third direction (e.g., Z direction) that is parallel to the direction in which the center axis 1306 extends.

The OPFE 1310 may include, for example, optical lenses formed as m groups, where m is a positive integer greater than zero (0). The m lenses may move in the second direction (Y-direction) and may change an optical zoom ratio of the camera module 1300b. For example, when a basic optical zoom ratio of the camera module 1300b is Z and m optical lenses included in the OPFE 1310 move, the optical zoom ratio of the camera module 1300b may be changed to 3Z, 5Z, or 10Z or greater.

The actuator 1330 may move the OPFE 1310 and/or the optical lens (hereinafter, referred to as optical lens) to a certain position. For example, the actuator 1330 may adjust the position of the optical lens such that the image sensor 1342 may be located at a focal length of the optical lens for exact sensing operation.

An image sensing device 1340 may include the image sensor 1342, a control logic 1344, and a memory 1346. The image sensor 1342 may sense an image of a sensing target by using the light L provided through the optical lens. The control logic 1344 may control the overall operation of the camera module 1300b. For example, the control logic 1344 may control the operations of the camera module 1300b according to a control signal provided through a control signal line CSLb.

For example, the image sensor 1342 may include the color separating lens array or the nano-photonic lens array described above. The image sensor 1342 may receive more signals separated according to wavelengths in each pixel by using the color separating lens array based on the nano-structures. Due to the above effects, the optical intensity needed to generate high quality images of high resolution and under the low illuminance may be secured.

The memory 1346 may store information that may be needed for the operation of the camera module 1300b (e.g., calibration data 1347). The calibration data 1347 may include information that may be needed to generate image data by using the light L provided from outside through the camera module 1300b. The calibration data 1347 may include, for example, information about the degree of rotation described above, information about the focal length, information about an optical axis, and the like. When the camera module 1300b is implemented in the form of a multi-state camera of which the focal length is changed according to the position of the optical lens, the calibration data 1347 may include information related to focal length values of the optical lens according to each position (or state) and auto-focusing.

The storage unit 1350 may store image data sensed through the image sensor 1342. The storage unit 1350 may be disposed out of the image sensing device 1340 and may be stacked with a sensor chip included in the image sensing device 1340. In some embodiments, the storage unit 1350 may be implemented as electrically erasable programmable read-only memory (EEPROM), however, the present disclosure is not limited thereto.

Referring to FIGS. 25 and 26, in some embodiments, each of the plurality of camera modules 1300a to 1300c may include the actuator 1330. Accordingly, each of the plurality of camera modules 1300a to 1300c may include the calibration data 1347 that may be the same as and/or different from the others, according to the operation of the actuator 1330 included therein.

In some embodiments, one (e.g., the second camera module 1300b) of the plurality of camera modules 1300a to 1300c (e.g., the second camera module 1300b) may be a camera module in a folded lens type including the prism 1305 and the OPFE 1310 described above, and the other camera modules (e.g., the first camera module 1300a and the third camera module 1300c) may be and/or may include vertical type camera modules not including the prism 1305 and the OPFE 1310. However, the present disclosure is not limited thereto.

In some embodiments, one of the plurality of camera modules 1300a to 1300c (e.g., the third camera module 1300c) may be a depth camera of a vertical type, which may extract depth information by using an IR ray.

In some embodiments, at least two camera modules from among the plurality of camera modules 1300a to 1300c (e.g., the first camera module 1300a and the second camera module 1300b) may have different fields of view. For example, the optical lenses of the at least two camera modules from among the plurality of camera modules 1300a to 1300c (e.g., the first camera module 1300a and the second camera module 1300b) may be different from each other. However, the present disclosure is not limited thereto.

In some embodiments, the plurality of camera modules 1300a to 1300c may have different fields of view from one another. For example, the optical lenses respectively included in the plurality of camera modules 1300a to 1300c may be different from one another, however, the present disclosure is not limited thereto.

In some embodiments, the plurality of camera modules 1300a to 1300c may be physically isolated from one another. That is, the sensing region of one image sensor 1342 may not be divided and used by the plurality of camera modules 1300a to 1300c, but the plurality of camera modules 1300a to 1300c may each have an independent image sensor 1342 provided therein.

Referring back to FIG. 25, the application processor 1400 may include an image processing device 1410, a memory controller 1420, and an internal memory 1430. The application processor 1400 may be separately implemented from the plurality of camera modules 1300a to 1300c. For example, the application processor 1400 and the plurality of camera modules 1300a to 1300c may be separately implemented as separate semiconductor chips.

The image processing device 1410 may include a plurality of image processors (e.g., first image processor 1411, second image processor 1412, and third image processor 1413), and a camera module controller 1414.

The image data generated by each of the camera modules 1300a to 1300c may be provided to the image processing device 1410 via separate image signal lines, respectively. The image data transfer may be carried out by using a camera serial interface (CSI) based on a MIPI, for example. However, the present disclosure is not limited thereto.

The image data transferred to the image processing device 1410 may be stored in an external memory 1600 before being transferred to the first and second image processors 1411 and 1412. The image data stored in the external memory 1600 may be provided to the first image processor 1411 and/or the second image processor 1412. The first image processor 1411 may correct the image data in order to generate video. The second image processor 1412 may correct the image data in order to generate still images. For example, the first and second image processors 1411 and 1412 may perform a pre-processing operation such as, but not limited to, a color calibration, a gamma calibration on the image data.

The image processor 1411 may include sub-processors. When the number of sub-processors is equal to the number of camera modules 1300a to 1300c, each of the sub-processors may process the image data provided from a corresponding camera module. When the number of sub-processors is less than the number of camera modules 1300a to 1300c, at least one of the sub-processors may process the image data provided from a plurality of camera module 1300a to 1300c by using a timing-sharing process. The image data processed by the first image processor 1411 and/or the second image processor 1412 may be stored in the external memory 1600 before being transferred to the third image processor 1413. The image data stored in the external memory 1600 may be transferred to the second image processor 1412. The second image processor 1412 may perform a post-processing operation such as, but not limited to, a noise calibration, a sharpen calibration, and the like, on the image data.

The image data processed in the third image processor 1413 may be provided to the image generator 1700. The image generator 1700 may generate a final image by using the image data provided from the third image processor 1413 according to image generating information or a mode signal.

That is, the image generator 1700 may generate the final image by merging at least parts of the image data generated by the camera modules 1300a to 1300c having different fields of view, according to image generating information and/or the mode signal. In an embodiment, the image generator 1700 may generate the output image by selecting one of pieces of image data generated by the camera modules 1300a to 1300c having different fields of view, according to image generating information or the mode signal.

In some embodiments, the image generating information may include a zoom signal or a zoom factor. For example, the mode signal may be and/or may include a signal based on a mode selected by a user.

When the image generating information is a zoom signal (zoom factor) and the plurality of camera modules 1300a to 1300c have different fields of view (angles of view) from one another, the image generator 1700 may perform different operations according to the type of zoom signal. For example, when the zoom signal is a first signal, the image data output from the first camera module 1300a may be merged with the image data output from the third camera module 1300c, and the output image may be generated by using the merged image signal and the image data output from the second camera module 1300b and not used in the merge. When the zoom signal is a second signal that is different from the first signal, the image generator 1700 may not perform the image data merging, and may generate the output image by selecting one piece of the image data output respectively from the plurality of camera modules 1300a to 1300c. However, the present disclosure is not limited thereto, and the method of processing the image data may be modified as needed.

The camera module controller 1414 may provide each of the plurality of camera modules 1300a to 1300c with a control signal. The control signals generated by the camera module controller 1414 may be provided to corresponding camera modules 1300a to 1300c via control signal lines (e.g., first control signal line CSLa, second control signal line CSLb, and third control signal line CSLc) separated from one another.

In some embodiments, the control signal provided to the plurality of camera modules 1300a to 1300c from the camera module controller 1414 may include mode information according to the mode signal. The plurality of camera modules 1300a to 1300c may operate in a first operation mode and/or a second operation mode in relation to the sensing speed, based on the mode information.

In the first operation mode, the plurality of camera modules 1300a to 1300c may generate the image signal at a first speed (e.g., generating an image signal of a first frame rate), may encode the image signal at a second speed that may be faster than the first speed (e.g., may encode the image signal at a second frame rate that may be greater than the first frame rate), and may transfer the encoded image signal to the application processor 1400. For example, the second speed may be 30 times faster than the first speed or less.

The application processor 1400 may store the received image signal (e.g., the encoded image signal) in the internal memory 1430 provided therein and/or the external memory 1600 outside the application processor 1400The application processor 1400 may decode the encoded signal from the internal memory 1430 and/or the external memory 1600, and may display the image data generated based on the decoded image signal. For example, the first and second image processors 1411 and 1412 in the image processing device 1410 may perform decoding, and may perform image processing on the decoded image signals.

In the second operation mode, he plurality of camera modules 1300a to 1300c may generate an image signal at a third speed that may be slower than the first speed (e.g., generating the image signal at a third frame rate that may be lower than the first frame rate), and may transfer the image signal to the application processor 1400. The image signal provided to the application processor 1400 may be a signal that is not encoded. The application processor 1400 may perform the image processing of the received image signal and/or store the image signal in the internal memory 1430 and/or the external memory 1600.

The PMIC 1500 may supply the power, for example, the power voltage, to each of the plurality of camera modules 1300a to 1300c. For example, the PMIC 1500 may supply the first power to the first camera module 1300a via a first power signal line PSLa, the second power to the second camera module 1300b via a second power signal line PSLb, and the third power to the third camera module 1300c via a third power signal line PSLc, under the control of the application processor 1400.

The PMIC 1500 may generate the power corresponding to each of the plurality of camera modules 1300a to 1300c and may adjust the power level, in response to a power control signal PCON from the application processor 1400. The power control signal PCON may include a power adjusting signal for each operation mode of the plurality of camera modules 1300a to 1300c. For example, the operation mode may include a low power mode, and the power control signal PCON may include information about the camera module operating in the low-power mode and set power level. The levels of the power provided to the plurality of camera modules 1300a to 1300c may be equal to or different from each other. Alternatively or additionally, the power level may be dynamically changed.

It is to be understood that embodiments described herein should be considered in a descriptive sense only and not for purposes of limitation. Descriptions of features or aspects within each embodiment may typically be considered as available for other similar features or aspects in other embodiments. While one or more embodiments have been described with reference to the figures, it is to be understood by those of ordinary skill in the art that various changes in form and details may be made therein without departing from the scope as defined by the following claims.

**Claims**

1. An image sensor, comprising:

   a sensor substrate comprising a plurality of pixels configured to sense light; and
   a spectral filter configured to separate incident light into at least four different wavelength bands and to provide the separated incident light to the plurality of pixels,
   wherein the spectral filter comprises:

   a routing filter array comprising a plurality of nano-structures configured to color-separate the incident light into at least three different wavelength bands and to condense the separated incident light onto the plurality of pixels; and
   a spectral filter array between the sensor substrate and the routing filter array, and comprising a plurality of unit filters having different transmission spectrums, the plurality of unit filters respectively corresponding to the plurality of pixels.

2. The image sensor of claim 1, wherein the routing filter array comprises a first meta-region, a second meta-region, a third meta-region, and a fourth meta-region,

> wherein each of the first meta-region, the second meta-region, the third meta-region, and the fourth meta-region correspond to one of the plurality of pixels and to one of the plurality of unit filters,
> wherein the plurality of nano-structures are disposed in each of the first meta-region, the second meta-region, the third meta-region, and the fourth meta-region, and
> wherein the plurality of nano-structures are further configured to change a phase of the incident light.

3. The image sensor of claim 2, wherein the plurality of nano-structures are further configured to:

> condense a first light of incident light onto first pixels corresponding to the first meta-region and the fourth meta-region, the first light having a first wavelength band, the incident light being incident on the first meta-region, the second meta-region, the third meta-region, and the fourth meta-region;
> condense a second light of the incident light onto a second pixel corresponding to the second meta-region, the second light having a second wavelength band; and
> condense a third light of the incident light onto a third pixel corresponding to the third meta-region, the third light having a third wavelength band.

4. The image sensor of claim 2, wherein the plurality of nano-structures are further configured to:

> condense a first light of incident light onto a first pixel corresponding to the first meta-region, the first light having a first wavelength band, the incident light being incident on the first meta-region, the second meta-region, the third meta-region, and the fourth meta-region;
> condense a second light of the incident light onto a second pixel corresponding to the second meta-region, the second light having a second wavelength band;
> condense a third light of the incident light onto a third pixel corresponding to the third meta-region, the third light having a third wavelength band;
> condense a fourth light of the incident light onto a fourth pixel corresponding to the fourth meta-region, the fourth light having a fourth wavelength band.

5. The image sensor of one of claims 1 to 4, wherein the routing filter array further comprises a first meta-region, a second meta-region, a third meta-region, and a fourth meta-region,

> wherein each of the first meta-region, the second meta-region, the third meta-region, and the fourth meta-region correspond to four pixels arranged in a 2×2 array from among the plurality of pixels and correspond to four unit filters arranged in the 2×2 array from among the plurality of unit filters, and
> wherein the plurality of nano-structures are disposed in each of the first meta-region, the second meta-region, the third meta-region, and the fourth meta-region, and
> wherein the plurality of nano-structures are further configured to change a phase of the incident light.

6. The image sensor of claim 5, wherein the plurality of nano-structures are further configured to:

> condense a first light of incident light onto four first pixels respectively corresponding to the first meta-region and the fourth meta-region, the first light having a first wavelength band, the incident light being incident on the first meta-region, the second meta-region, the third meta-region, and the fourth meta-region;
> condense a second light of the incident light onto four second pixels corresponding to the second meta-region, the second light having a second wavelength band; and
> condense a third light of the incident light onto four third pixels corresponding to the third meta-region, the third light having a third wavelength band, or
> wherein the plurality of nano-structures are further configured to:

>> condense a first light of incident light onto four first pixels corresponding to the first meta-region, the first light having a first wavelength band, the incident light being incident on the first meta-region, the second meta-region, the third meta-region, and the fourth meta-region;
>> condense a second light of the incident light onto four second pixels corresponding to the second meta-region, the second light having a second wavelength band;
>> condense a third light of the incident light onto four third pixels corresponding to the third meta-region, the third light having a third wavelength band; and
>> condense a fourth light of the incident light onto four fourth pixels corresponding to the fourth meta-region, the fourth light having a fourth wavelength band.

7. The image sensor of one of claims 1 to 6, wherein each of the plurality of unit filters comprises:

a first reflector;
a second reflector above the first reflector; and
a cavity between the first reflector and the second reflector, and
wherein each of the plurality of unit filters has a transmission spectrum with at least two different transmission peak wavelengths.

8. The image sensor of claim 7, wherein a plurality of cavities of the plurality of unit filters have a same thickness.

9. The image sensor of claim 7, wherein the cavity comprises:

a cavity lower layer having a lower dielectric pattern formed by a first dielectric material having a first refractive index and a second dielectric material having a second refractive index that is greater than the first refractive index; and
a cavity upper layer having an upper dielectric pattern formed by a third dielectric material having a third refractive index and a fourth dielectric material having a fourth refractive index that is greater than the third refractive index.

10. The image sensor of claim 9, wherein a first effective refractive index of the cavity lower layer is determined according to a first volume ratio of a first volume occupied by the first dielectric material to a second volume occupied by the second dielectric material in the cavity lower layer,

wherein a second effective refractive index of the cavity upper layer is determined according to a second volume ratio of a third volume occupied by the third dielectric material to a fourth volume occupied by the fourth dielectric material in the cavity upper layer, and
wherein the effective refractive indexes and thicknesses of the cavity lower layer and the cavity upper layer are determined in each of the plurality of unit filters, such that each of the plurality of unit filters has a transmission spectrum having at least two different peak wavelengths.

11. The image sensor of claim 10, wherein two or more of a plurality of cavities in the plurality of unit filters have same lower dielectric patterns and same upper dielectric patterns, or

wherein a plurality of spectral channels are formed by combinations of the routing filter array and the plurality of unit filters of the spectral filter array, and a number of cavities of a plurality of cavities having different lower dielectric patterns or different upper dielectric patterns in the spectral filter array being less than a number of spectral channels, or
wherein, based on the image sensor having N spectral channels and the routing filter array separating and condensing the incident light of A wavelength bands, a number N' of cavities having different lower dielectric patterns or different upper dielectric patterns satisfies a condition $\frac{N}{A} \leq N' < N$, and wherein N and A are positive integers greater than or equal to four.

12. The image sensor of claim 9, wherein the cavity further comprises a dielectric separation layer between the cavity lower layer and the cavity upper layer, and
wherein the dielectric separation layer has a refractive index less than or equal to the second refractive index or the fourth refractive index.

13. The image sensor of claim 12, wherein the dielectric separation layer comprises at least one of hafnium oxide, $HfO_2$, or titanium oxide, $TiO_2$, or
wherein the dielectric separation layer has a thickness of 10 nm to 100 nm.

14. The image sensor of one of claims 1 to 13, wherein a bandwidth of the transmission spectrum of the routing filter array is greater than a bandwidth of the transmission spectrum of each of the plurality of unit filters in the spectral filter array, or
wherein the spectral filter further comprises a spacer layer between the spectral filter array and the routing filter array, and the spacer layer having a refractive index that is less than refractive indexes of the plurality of nano-structures.

15. An electronic apparatus, comprising:

a lens assembly configured to form an optical image of a subject;
an image sensor configured to convert the optical image formed by the lens assembly into an electrical signal; and
a processor configured to process a signal generated by the image sensor,
wherein the image sensor is arranged in accordance with one of claims 1 to 14.

# FIG. 1

1000

1100

1020 — ROW DECODER

1010 — T/C

1030

OUTPUT CIRCUIT

# FIG. 2

# FIG. 3

300

| | | | |
|------|------|------|------|
| R1 | R2 | R1 | R2 |
| R3 | R4 | R3 | R4 |
| R1 | R2 | R1 | R2 |
| R3 | R4 | R3 | R4 |

Y

Z ⊙ → X

# FIG. 4

# FIG. 5

# FIG. 6

# FIG. 7

300

GL

| R1 | R2 | R1 | R2 |
| R3 | R4 | R3 | R4 |
| R1 | R2 | R1 | R2 |
| R3 | R4 | R3 | R4 |

Y

Z X

# FIG. 8

300

| R1 | R2 | R1 | R2 |
| R3 | R4 | R3 | R4 |
| R1 | R2 | R1 | R2 |
| R3 | R4 | R3 | R4 |

BL

Y

Z X

# FIG. 9

RL

300

| R1 | R2 | R1 | R2 |
|----|----|----|----|
| R3 | R4 | R3 | R4 |
| R1 | R2 | R1 | R2 |
| R3 | R4 | R3 | R4 |

Y

Z → X

# FIG. 10

200

S

S

| F1 | F3 | F5 | F7 |
|----|----|----|----|
| F2 | F4 | F6 | F8 |
| F9 | F11 | F13 | F15 |
| F10 | F12 | F14 | F16 |

# FIG. 11

# FIG. 12A

226a

226b

# FIG. 12B

226b

226a

FIG. 12C

FIG. 12D

# FIG. 13A

226a

226b

# FIG. 13B

226a

226b

# FIG. 14

# FIG. 15

# FIG. 16A

# FIG. 16B

# FIG. 17A

# FIG. 17B

# FIG. 18

# FIG. 19

# FIG. 20

200

| F1<br>(PT1) | F3<br>(PT4) | F5<br>(PT4) | F7<br>(PT7) |
|---|---|---|---|
| F2<br>(PT2) | F4<br>(PT3) | F6<br>(PT5) | F8<br>(PT6) |
| F9<br>(PT2) | F11<br>(PT3) | F13<br>(PT5) | F15<br>(PT6) |
| F10<br>(PT1) | F12<br>(PT8) | F14<br>(PT8) | F16<br>(PT7) |

Y

Z⊙ → X

# FIG. 21

## FIG. 22

# FIG. 23

ED00

ELECTRONIC DEVICE  ED01

ED30

ED40

PROGRAM
ED46

APPLICATION

ED44

MIDDLEWARE

ED42

OPERATING SYSTEM

ED50

INPUT
DEVICE

ED60

DISPLAY
DEVICE

MEMORY  ED32

VOLATILE MEMORY

ED34

NON-VOLATILE MEMORY

INTERNAL
MEMORY  ED36

EXTERNAL
MEMORY  ED38

ED55

SOUND
OUTPUT
DEVICE

ED89

BATTERY

ED20

PROCESSOR

ED21

MAIN
PROCESSOR

ED90

COMMUNICATION MODULE

WIRELESS
COMMUNICATION MODULE

WIRED
COMMUNICATION MODULE

ED92

ED94  ED99

NETWORK

ED04

ELECTRONIC
DEVICE

ED88

POWER
MANAGEMENT
MODULE

ED23

AUXILIARY
PROCESSOR

ED96

SUBSCRIBER
IDENTIFICATION
MODULE

ED97

ANTENNA
MODULE

ED98

ED70

AUDIO
MODULE

ED76

SENSOR
MODULE

ED77

INTERFACE

ED78

CONNECTION
TERMINAL

ED02

ELECTRONIC
DEVICE

ED08

SERVER

ED79

HAPTIC
MODULE

ED80

CAMERA
MODULE

# FIG. 24

ED80

1120 — FLASH

1110 — LENS ASSEMBLY

1000 — IMAGE SENSOR

1140 — IMAGE STABILIZER

1150 — MEMORY

1160 — IMAGE SIGNAL PROCESSOR

# FIG. 25

# FIG. 26

## EUROPEAN SEARCH REPORT

Application Number

EP 24 20 5304

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/020980 A1 (MUN SANGEUN [KR] ET AL) 19 January 2023 (2023-01-19) | 1-6,15 | INV. H10F39/00 |
| Y | * paragraph [0104] - paragraph [0106]; figures 17-19 * | 7-14 | |
| | ----- | | |
| Y | US 2022/336777 A1 (DO YUN SEON [KR] ET AL) 20 October 2022 (2022-10-20) * paragraph [0076] - paragraph [0112]; figures 3A,3B * | 7-14 | |
| | ----- | | |
| A | US 2022/342130 A1 (KIM HYOCHUL [KR] ET AL) 27 October 2022 (2022-10-27) * the whole document * | 7-14 | |
| | ----- | | |

**TECHNICAL FIELDS SEARCHED (IPC)**

H10F

The present search report has been drawn up for all claims

| Place of search | Date of completion of the search | Examiner |
|---|---|---|
| The Hague | 24 March 2025 | Hedouin, Mathias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 5304

This annex lists the patent family members relating to the patent documents cited in the above-mentioned European search report.
The members are as contained in the European Patent Office EDP file on
The European Patent Office is in no way liable for these particulars which are merely given for the purpose of information.

24-03-2025

| Patent document cited in search report | Publication date | Patent family member(s) | | Publication date |
|---|---|---|---|---|
| US 2023020980 A1 | 19-01-2023 | CN | 115621290 A | 17-01-2023 |
| | | EP | 4120347 A1 | 18-01-2023 |
| | | KR | 20230012366 A | 26-01-2023 |
| | | US | 2023020980 A1 | 19-01-2023 |
| US 2022336777 A1 | 20-10-2022 | KR | 20220142078 A | 21-10-2022 |
| | | US | 2022336777 A1 | 20-10-2022 |
| US 2022342130 A1 | 27-10-2022 | CN | 115241217 A | 25-10-2022 |
| | | EP | 4086673 A1 | 09-11-2022 |
| | | JP | 7471340 B2 | 19-04-2024 |
| | | JP | 2022167835 A | 04-11-2022 |
| | | US | 2022342130 A1 | 27-10-2022 |

EPO FORM P0459

For more details about this annex : see Official Journal of the European Patent Office, No. 12/82